# EUROPEAN PATENT APPLICATION

(11) **EP 4 651 205 A1**
(43) Date of publication of application: **19.11.2025**
(21) Application number: 24741771.0
(22) Date of filing: 15.01.2024
(51) Int. Cl.: H01L 23/498, H01L 23/538, H01L 23/31, H01L 25/10, H01L 23/13

(54) **CIRCUIT BOARD AND SEMICONDUCTOR PACKAGE COMPRISING SAME**

(30) Priority: 13.01.2023 KR 20230005583
(71) Applicant: LG INNOTEK CO. LTD, Gangseo-gu Seoul 07796 (KR)
(72) Inventor: YOO, Ho Dol, Seoul 07796 (KR)
(74) Representative: Plasseraud IP
(86) International application number: PCT/KR2024/000705
(87) International publication number: WO 2024/151150

(57) **Abstract**

A semiconductor package according to an embodiment includes an insulating layer; an electrode part disposed on the insulating layer; and a protective layer disposed on the electrode part, wherein the protective layer includes a first region provided around an upper surface of the protective layer; and a second region excluding the first region, and a step is provided between an upper surface of the first region and an upper surface of the second region.

## Description

### [Technical Field]

The embodiment relates to a circuit board and a semiconductor package comprising the same.

### [Background Art]

High performance of electric/electronic products is progressing, and accordingly, techniques for attaching a greater number of packages to a substrate having a limited size have been proposed and studied. However, a general package basically includes one semiconductor chip, and thus has limitations in having desired performance.

A general semiconductor package has a form in which a processor package in which a processor chip is disposed and a memory package to which a memory chip is attached are connected as one. The semiconductor package has advantages of reducing a chip mounting area and enabling high-speed signals through a short pass by manufacturing a processor chip and a memory chip into one integrated package.

The package substrate can provide these advantages and is widely applied to mobile devices and the like.

On the other hand, a size of a package is increasing due to the high specification of electronic devices such as mobile devices and the adoption of High Bandwidth Memory (HBM). Accordingly, a semiconductor package including an interposer is mainly used.

That is, the semiconductor package includes a package substrate, a semiconductor device disposed on the package substrate, and a memory substrate disposed on the package substrate. The memory substrate may be connected through a separate interposer, or the memory substrate may be directly coupled to the package substrate.

In addition, the package substrate includes a mounting pad connected to the semiconductor device and a first insulating layer (e.g., a solder resist or a protective layer) including an opening overlapping an upper surface of the mounting pad in a vertical direction.

On the other hand, a number of terminals of the semiconductor device is gradually increasing for reasons such as 5G, Internet of Things (IOT), image quality increase, and communication speed increase. Accordingly, a number of mounting pads included in the package substrate and a number of openings of the first insulating layer are also increasing.

In this case, there is a limit to a minimum size of the opening that can be formed in the first insulating layer, and accordingly, there is a problem in that mounting pads connected to terminals of the semiconductor device cannot be disposed within a limited space. Accordingly, a conventional semiconductor package has a problem in that circuit integration density is deteriorated and an overall size is increased.

Accordingly, there is a demand for a semiconductor package including a first insulating layer having a novel structure capable of reducing the size of the semiconductor package and arranging all mounting pads connected to terminals of the semiconductor device in a limited space.

(Patent Document 1) KR 10-2016-0138753 A

### [Disclosure]

### [Technical Problem]

The embodiment provides a circuit board having a novel structure and a semiconductor package including the same.

In addition, the embodiment provides a circuit board capable of stably protecting a conductive bonding part and a semiconductor package including the same.

In addition, the embodiment provides a circuit board capable of preventing a connection member from spreading and a semiconductor package including the same.

In addition, the embodiment provides a circuit board capable of improving molding processability of a semiconductor device and a semiconductor package including the same.

In addition, the embodiment provides a circuit board including a protective layer having a novel open structure and a semiconductor package including the same.

In addition, the embodiment provides a circuit board capable of improving a circuit integration density and a semiconductor package including the same.

In addition, the embodiment provides a circuit board having improved physical reliability and electrical reliability and a semiconductor package including the same.

In addition, the embodiment provides a circuit board capable of being slimmed down and miniaturized and a semiconductor package including the same.

Technical problems to be solved by the proposed embodiments are not limited to the above-mentioned technical problems, and other technical problems not mentioned may be clearly understood by those skilled in the art to which the embodiments proposed from the following descriptions belong.

### [Technical Solution]

A semiconductor package according to an embodiment comprises an insulating layer; an electrode part disposed on the insulating layer; a protective layer disposed on the electrode part; and a semiconductor device disposed on the protective layer, wherein the protective layer includes: a first region that overlaps the semiconductor device in a vertical direction, and a second region that is disposed at an outside of the first region and does not overlap the semiconductor device in the vertical direction, and wherein a step is provided between an upper surface of the first region and an upper surface of the second region.

In addition, the upper surface of the first region is positioned lower than the upper surface of the second region.

In addition, the second region is provided along a circumferential direction of an upper surface of the protective layer, and the first region is provided at an inside of the second region.

In addition, the upper surface of the second region of the protective layer is positioned higher than a lower surface of the semiconductor device and lower than an upper surface of the semiconductor device.

In addition, the protective layer includes: a first protective layer disposed on the insulating layer and including a through hole overlapping the semiconductor device in the vertical direction; and a second protective layer disposed inside the through hole of the first protective layer and spaced apart from the first protective layer.

In addition, the first protective layer includes the first region and the second region, and an upper surface of the second protective layer is disposed on a same plane as the upper surface of the first region of the first protective layer.

In addition, the first protective layer includes the first region and the second region, and an upper surface of the second protective layer is positioned lower than the upper surfaces of each of the first and second regions of the first protective layer.

In addition, the semiconductor package further comprises a conductive bonding part passing through at least a part of the second region of the first protective layer, the conductive bonding part is disposed on a first electrode of the electrode part that does not overlap with the semiconductor device in the vertical direction, the second region of the first protective layer includes a first opening that overlaps with the conductive bonding part in the vertical direction, and the second region of the first protective layer is provided to entirely surround a side surface of the conductive bonding part.

In addition, an upper surface of the conductive bonding part is positioned higher than a lower surface of the semiconductor device and lower than an upper surface of the semiconductor device.

In addition, an inner surface of the through hole of the first protective layer includes a protruding surface protruding toward the second protective layer.

In addition, an outer surface of the second protective layer includes a protruding surface protruding toward the first protective layer.

In addition, a distance in a horizontal direction between the inner surface of the through hole of the first protective layer and the outer surface of the second protective layer includes different distances along the inner surface of the through hole.

In addition, a separation region is formed between the inner surface of the through hole of the first protective layer and the outer surface of the second protective layer, and overlaps with the through hole in the vertical direction and does not overlap with the second protective layer in the vertical direction.

In addition, the semiconductor device includes first and second semiconductor devices spaced apart in the horizontal direction.

In addition, the semiconductor package further includes a connection member embedded in the insulating layer and vertically overlapping with a portion of the first semiconductor device and a portion of the second semiconductor device, respectively.

In addition, the semiconductor package further includes an external substrate disposed on the conductive bonding part.

In addition, the semiconductor package further includes a molding layer disposed on the semiconductor device, and a lower surface of the molding layer has a step corresponding to the step of the first and second regions of the protective layer.

### [Advantageous Effects]

The embodiment can simplify a manufacturing process of a semiconductor package, improve the product yield, and improve physical reliability and/or electrical reliability of the semiconductor package.

That is, the semiconductor package of the embodiment includes an insulating layer and a protective layer disposed on the insulating layer. At this time, an upper surface of the protective layer has a step. Specifically, the protective layer includes a first region that overlaps the semiconductor device in a vertical direction; and a second region excluding the first region, and an upper surface of the first region and an upper surface of the second region have a step. Preferably, the upper surface of the first region is positioned lower than the upper surface of the second region. Therefore, the step between the first region and the second region of the protective layer of the embodiment can function as a dam in a process of applying a contacting part such as solder to mount the semiconductor device. For example, the step between the first region and the second region of the protective layer can guide a mounting position so that the contacting part moves to a designated position. Accordingly, the embodiment can ensure that the contacting part is mounted at an accurate position, and can provide ease of manufacturing process accordingly. Furthermore, the embodiment can prevent the contacting part from being moved to an outside of the semiconductor package and discarded by using the step between the first region and the second region of the protective layer, thereby reducing the product manufacturing cost. Furthermore, the embodiment can provide ease of manufacturing process of the semiconductor package, and further improve the product yield.

In addition, the second region of the protective layer of the embodiment is provided to surround a circumference of the conductive bonding part. Preferably, the second region of the protective layer of the embodiment is provided to entirely surround a side surface of the conductive bonding part. Accordingly, the embodiment does not need to form a separate molding member to surround the side surface of the conductive bonding part, thereby simplifying the manufacturing process.

Furthermore, the embodiment is provided such that the side surface of the conductive bonding part is entirely covered by the protective layer. Through this, the stress applied to the conductive bonding part can be minimized, and thus the reliability problem of cracks occurring at an interface between the conductive bonding part and the electrode part due to the concentration of stress on the conductive bonding part can be solved.

For example, according to a conventional technology, a part of the side surface of the conductive bonding part is covered with a protective layer, and a remaining part of the conductive bonding part is covered with a molding member. At this time, the protective layer and the molding member include different insulating materials, and thus have different thermal expansion coefficients. Therefore, one of the protective layer and the molding member may expand or contract more than the other. Therefore, different stresses may be applied to the side surface of the conductive bonding part that contacts the molding member and the side surface of the conductive bonding part that contacts the protective layer, and thus the physical reliability of the conductive bonding part may be deteriorated.

In addition, according to another conventional technology, the side surface of the conductive bonding part may be entirely in contact with the molding member. At this time, the molding member is laminated after a semiconductor device is mounted on a circuit board. Therefore, upper and side surfaces of the conductive bonding part may be entirely exposed in a process of mounting the semiconductor device. Therefore, a physical impact may be applied to the conductive bonding part in a process of mounting the semiconductor device, and as a result, a problem of the conductive bonding part being peeled off from the electrode part may occur. In addition, during a process of mounting a semiconductor device, foreign substances may accumulate on the upper surface of the conductive bonding part, which may deteriorate the electrical reliability of the conductive bonding part.

In contrast, in the embodiment, the protective layer is provided to completely surround the side surface of the conductive bonding part. Through this, the embodiment can uniformly apply stress to the entire region of the conductive bonding part according to the expansion or contraction of the protective layer, thereby solving the physical reliability problem of the conductive bonding part being peeled off from the electrode part.

Furthermore, the embodiment can stably protect the conductive bonding part from impact applied during the process of mounting a semiconductor device, thereby improving the physical reliability and/or electrical reliability of the conductive bonding part.

In addition, the protective layer of the embodiment includes a first protective layer including first and second regions and having a through hole, and a second protective layer provided at an inner side of the through hole of the first protective layer. At this time, the first protective layer includes a protruding surface protruding toward the second protective layer. For example, an outer surface of the second protective layer includes a protruding surface protruding toward the first protective layer. Accordingly, a separation distance or a spacing in a horizontal direction between the inner surface of the through hole of the first protective layer and the outer surface of the second protective layer may include different separation distances or spacings along the inner surface of the through hole. For example, the separation distance may include a first separation distance and a second separation distance. In addition, the first separation distance and the second separation distance may be different from each other. For example, the first separation distance may be greater than the second separation distance.

At this time, the embodiment may be such that second electrodes and/ traces of the electrode part having a greater density may be concentrated in the first separation region corresponding to the first separation distance than in the second separation region corresponding to the second separation distance. For example, a distance between second electrodes and/or traces disposed in the first separation region may be smaller than a distance between second electrodes and/or traces disposed in the second separation region. This means that an integration density of the electrode part in the first separation region is higher than an integration density of the electrode part in the second separation region.

In this case, the second electrodes and the traces may be disposed in the first and second separation regions with a same integration density. However, it may increase the distance between the second electrodes to be connected to each other, thereby increasing the signal transmission loss. Furthermore, when the second electrodes and traces are disposed with a same integration density in the first and second separation regions, an overall area of the separation region may increase because the first electrodes where mutual signal interference occurs should be farther apart. In addition, when the overall area of the separation region increases, a number of electrodes or traces not protected by the first protective layer and the second protective layer increases, and accordingly, it may cause physical reliability and electrical reliability problems.

In addition, first electrodes and traces having different integration densities may be disposed in the first and second separation regions, and the separation distances of the separation regions may be the same along a circumference of the inner surface of the first protective layer. However, it increases the area of electrodes and traces not covered by the first protective layer or the second protective layer, and accordingly, it may cause a problem that the electrode or trace is delaminated due to thermal stress or the like.

Accordingly, the separation region has a first separation distance and a second separation distance different from each other along the circumference of the inner surface of the first protective layer and the outer surface of the second protective layer. Therefore, the embodiment can improve signal transmission characteristics by having different circuit integration densities in the separation region and minimizing signal transmission loss due to a decrease in signal transmission distance. In addition, the embodiment allows a separation distance of a region having a relatively low circuit integration density among the separation regions smaller than a separation distance of a region having a high circuit integration density. Accordingly, the embodiment can minimize a reliability problem due to a trace not being covered by the first protective layer or the second protective layer in a separation region having a small separation distance. Furthermore, the embodiment may further improve electrical reliability and physical reliability of a semiconductor package.

### [Description of Drawings]

FIG. 1 is a cross-sectional view illustrating a semiconductor package according to a first embodiment.
FIG. 2 is a cross-sectional view illustrating a semiconductor package according to a second embodiment.
FIG. 3 is a cross-sectional view illustrating a semiconductor package according to a third embodiment.
FIG. 4 is a plan view of a first protective layer according to a first embodiment.
FIG. 5 is a plan view of a second protective layer according to an embodiment.
FIG. 6 is a plan view showing a state in which a second protective layer is disposed in a through hole of a first protective layer according to an embodiment.
FIG. 7 is a cross-sectional view of one embodiment taken along direction A-A' of FIG. 6.
FIG. 8 is a cross-sectional view showing a state in which a semiconductor device is disposed in a semiconductor package of FIG. 7.
FIG. 9 is a cross-sectional view of another embodiment cut taken direction A-A' of FIG. 6.
FIG. 10 is a plan view of a first protective layer according to a second embodiment.
FIG. 11 is a cross-sectional view showing a state in which a semiconductor device is disposed in a semiconductor package including the first protective layer of FIG. 10.
FIG. 12 is an enlarged view of region B of FIG. 6.
FIG. 13 is a plan view showing a first electrode part provided in region A of FIG. 1.
FIG. 14 is a plan view showing a state in which the first and second protective layers are disposed on the first electrode part of FIG. 13.
FIGS. 15 to 31 are cross-sectional views for explaining a manufacturing method of a semiconductor package according to an embodiment in order of processes.

### [Mode for Invention]

Hereinafter, exemplary embodiments of the present invention will be described in detail with reference to the accompanying drawings, wherein like reference numerals are used to designate identical or similar elements, and redundant description thereof will be omitted. The suffix "module" and "portion" of the components used in the following description are only given or mixed in consideration of ease of preparation of the description, and there is no meaning or role to be distinguished as it is from one another. Also, in the following description of the embodiments of the present invention, a detailed description of related arts will be omitted when it is determined that the gist of the embodiments disclosed herein may be obscured. Also, the accompanying drawings are included to provide a further understanding of the invention, are incorporated in, and constitute a part of this description, and it should be understood that the invention is intended to cover all modifications, equivalents, or alternatives falling within the spirit and scope of the invention.

Terms including ordinals, such as first, second, etc., may be used to describe various components, but the elements are not limited to these terms. The terms are used only for distinguishing one component from another.

When a component is referred to as being "connected" or "contacted" to another component, it may be directly connected or joined to the other component, but it should be understood that other component may be present therebetween. When a component is referred to as being "directly connected" or "directly contacted" to another component, it should be understood that other component may not be present therebetween.

A singular representation includes plural representations, unless the context clearly implies otherwise.

In the present application, terms such as "including" or "having" are used to specify the presence of features, numbers, steps, operations, components, parts, or combinations thereof described in the description. However, it should be understood that the terms do not preclude the presence or addition of one or more other features, numbers, steps, operations, components, parts, or combinations thereof.

Hereinafter, embodiments of a present invention will be described in detail with reference to attached drawings.

### -Electronic device-

Before describing an embodiment, an electronic device to which a semiconductor package of the embodiment is applied will be briefly described. An electronic device includes a main board (not shown). The main board may be physically and/or electrically connected to various components. For example, the main board may be connected to the semiconductor package of the embodiment. Various semiconductor devices may be mounted on the semiconductor package.

The semiconductor device may include an active device and/or a passive device. The active device may be a semiconductor device in the form of an integrated circuit (IC) in which hundreds to millions of devices are integrated into a single chip. The semiconductor device may be a logic chip, a memory chip, or the like. The logic chip may be a central processor (CPU), a graphic processor (GPU), or the like. For example, the logic chip may be an application processor (AP) semiconductor device including at least one of a central processor (CPU), a graphic processor (GPU), a digital signal processor, a cryptographic processor, a microprocessor, and a microcontroller, or an analog-to-digital converter, an application-specific IC (ASIC), etc., or a chip set that includes a specific combination of those listed so far.

The memory chip may be a stack memory such as HBM. Also, the memory chip may include a memory chip such as a volatile memory (e.g., DRAM), a non-volatile memory (e.g., ROM), or a flash memory.

On the other hand, a product group to which the semiconductor package of the embodiment is applied include CSP (Chip Scale Package), FC-CSP (Flip Chip-Chip Scale Package), FC-BGA (Flip Chip Ball Grid Array), POP (Package On Package), and SIP ( System In Package), but is not limited thereto.

In this case, the electronic device may include a smart phone, a personal digital assistant, a digital video camera, a digital still camera, a vehicle, a high-performance server, a network system, a computer, a monitor, a tablet, a laptop, a netbook, a television, a video game, a smart watch, an automotive, and the like. However, the embodiment is not limited thereto, and may be any other electronic device that processes data in addition to these.

### -Semiconductor Package-

Hereinafter, a semiconductor package according to an exemplary embodiment will be described.

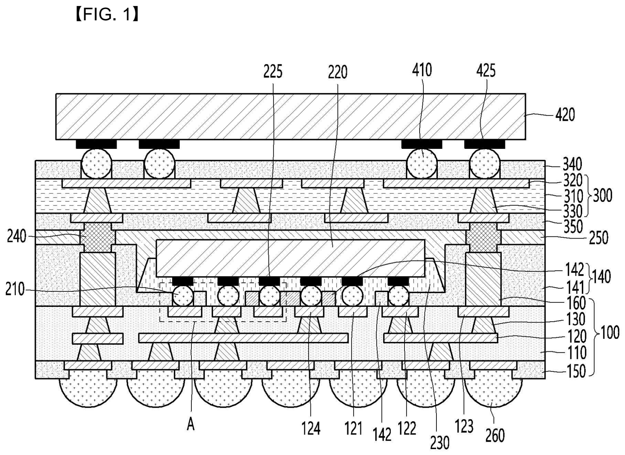

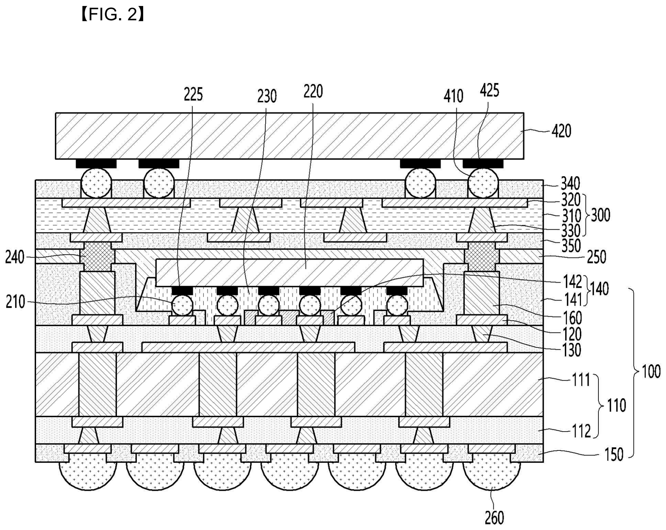

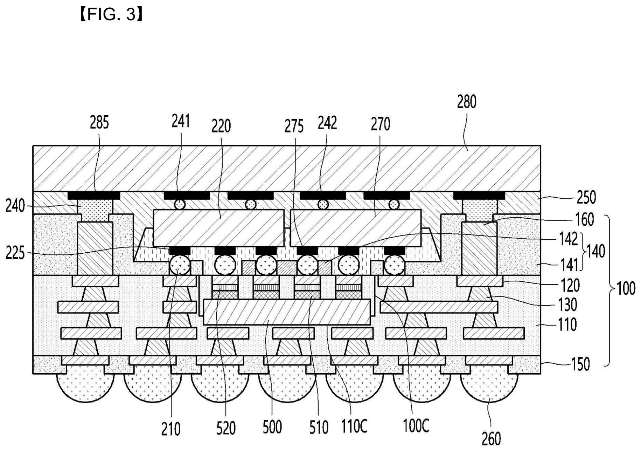

FIG. 1 is a cross-sectional view illustrating a semiconductor package according to a first embodiment, FIG. 2 is a cross-sectional view illustrating a semiconductor package according to a second embodiment, and FIG. 3 is a cross-sectional view illustrating a semiconductor package according to a third embodiment.

Hereinafter, a schematic structure of the semiconductor package of the embodiment is described with reference to FIGS. 1 to 3.

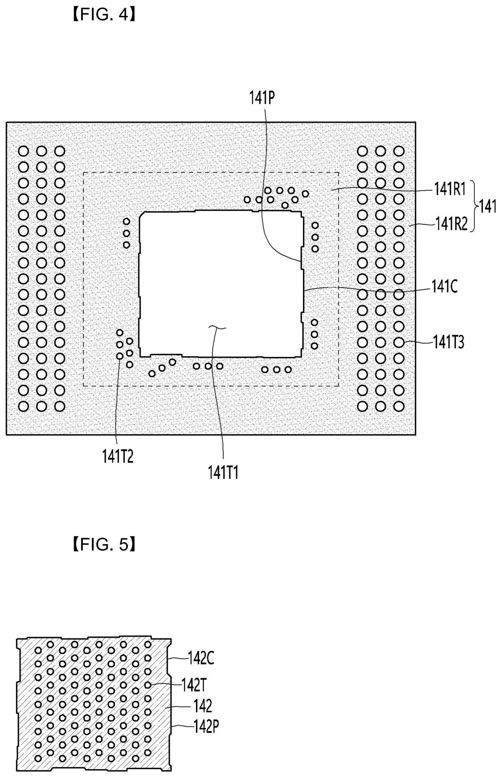

Meanwhile, a structure of a protective layer provided in the semiconductor package is described in detail with reference to drawings after FIG. 4.

Referring to FIG. 1, a semiconductor package includes a circuit board 100. The circuit board 100 may mean a package substrate, but is not limited thereto.

The circuit board 100 can provide a space in which at least one semiconductor device is mounted. Alternatively, the circuit board 100 can provide a space in which at least one external substrate is coupled.

The circuit board 100 can provide a space in which a first external substrate is coupled. The first external substrate may refer to a main board included in an electronic device.

The circuit board 100 can provide a space in which a second external substrate is coupled. The second external substrate may be an interposer. For example, the second external substrate may be an interposer that electrically connects between the semiconductor device and the circuit board 100. The interposer may be either an active interposer or a passive interposer.

### The circuit board 100 includes an insulating layer 110.

The insulating layer 110 may include an organic material that has excellent processability, allows for slimming of the circuit board, and does not include a reinforcing member that allows for miniaturization of the electrode part of the circuit board. For example, the insulating layer 110 of the circuit board can use ABF (Ajinomoto Build-up Film), a product released by Ajinomoto Co., Ltd., as an example, or FR-4, BT (Bismaleimide Triazine), PID (Photo Imageable Dielectric resin), BT, etc.

The insulating layer 110 can be provided in a plurality of layers. The insulating layer 110 can be an inner layer of the circuit board 100. The inner layer can mean that another insulating layer (e.g., a protective layer) can be disposed on at least one of upper and lower layers of the insulating layer 110.

When the insulating layer 110 is provided in a plurality of layers, each of the plurality of layers of the insulating layer 110 can be provided with a same insulating material, but is not limited thereto, and at least one layer can be provided with an insulating material different from other layers.

Meanwhile, when the plurality of layers of the insulating layer 110 are provided with a same insulating material, multiple interlayer interfaces of the insulating layer 110 may not be easily distinguished. In this case, interlayer distinction may be made by electrode parts 120 and 130 disposed within the insulating layer 110.

The electrode parts 120 and 130 include first electrode parts 120 respectively provided at multiple interlayer interfaces. In addition, the electrode parts 120 and 130 include second electrode parts 130 provided between the first electrode parts 120 disposed in different layers. The second electrode part 130 may be referred to as a via electrode.

A width in a horizontal direction of the first electrode part 120 is different from a width in the horizontal direction of the second electrode part 130. Therefore, interlayer distinction may be made by utilizing a difference in the widths of the first electrode part 120 and the second electrode part 130. In addition, a slope of a side surface of the first electrode part 120 may be different from a slope of a side surface of the second electrode part 130. Therefore, interlayer distinction can be achieved by utilizing the difference between the slope of the side surface of the first electrode part 120 and the slope of the side surface of the second electrode part 130.

Meanwhile, even if each of the plurality of layers of the insulating layer 110 includes a same insulating material, the interface between them may be distinguished.

Through a laminated structure of the insulating layer 110 described above, the circuit board 100 of the embodiment may efficiently electrically connect at least one semiconductor device and/or a second circuit board to a main board.

Meanwhile, at least one layer of the multiple layers of the insulating layer 110 may include a reinforcing member. In one embodiment, the reinforcing member may mean glass fiber. In another embodiment, the reinforcing member may mean GCP (Glass Core Primer).

The reinforcing member is distinguished from a filler. For example, the reinforcing member may include a reinforcing material extending in a horizontal direction within the insulating layer 110, which has a different meaning from an inorganic filler that is spaced apart from each other. For example, a length or width of in the horizontal direction of the reinforcing member is different from a horizontal length or width in the horizontal direction of the filler. For example, the reinforcing member may be disposed in a curved shape within the insulating layer 110, and thus the width in the horizontal direction of the reinforcing member may be greater than the width in the horizontal direction of the insulating layer 110.

The embodiment may improve a rigidity of the circuit board 100 by including the reinforcing member in at least one layer among a plurality of layers of the insulating layer 110. For example, the reinforcing member may prevent the circuit board 100 from being significantly bent in a specific direction. Therefore, the reinforcing member may prevent the insulating layer 110 from being bent during a manufacturing process of the circuit board 100, and thereby improve positional accuracy of the first electrode part 120 and the second electrode part 130. In addition, as the rigidity of the circuit board 100 is secured, the semiconductor device can be stably coupled on the circuit board 100, and thus operating characteristics of the semiconductor device can be improved. In addition, as the rigidity of the circuit board 100 is secured, a connection member (500, see FIG. 3) can be stably embedded in the circuit board. Accordingly, the circuit board 100 of the embodiment can stably support the connection member 500, and thereby minimize a thermal stress transmitted to the connection member 500. Therefore, the embodiment can improve signal transmission characteristics of the connection member 500. Furthermore, the electronic product and/or server to which the semiconductor package of the embodiment is applied can be stably operated, and thus product reliability can be improved.

When the insulating layer 110 is provided in multiple layers, each of the multiple layers can have a thickness in a range of 10 µm to 40 µm. Preferably, each of the plurality of layers of the insulating layer 110 can satisfy a thickness in a range of 15 µm to 35 µm. More preferably, each of the plurality of layers of the insulating layer 110 can satisfy a thickness in a range of 18 µm to 32 µm.

The thickness of each of the plurality of layers of the insulating layer 110 corresponds to a distance in the vertical direction of the circuit board between the first electrode parts 120 disposed in different layers. That is, the thickness may mean a length in a direction from the upper surface of the circuit board 100 to the lower surface of the circuit board 100, or from the lower surface to the upper surface, and may mean a length in the vertical direction. Here, the upper surface may mean a highest position along the vertical direction in each component, and the lower surface may mean a lowest position along the vertical direction in each component. In addition, the positions thereof may be referred to oppositely.

If the thickness of each layer of the insulating layer 110 is less than 10 µm, warpage characteristics of the circuit board 100 may deteriorate, and as a result, the circuit board 100 may be greatly bent in a specific direction. If the thickness of each layer of the insulating layer 110 is less than 10 µm, the electrode part 120 and 130 may not be stably protected, and thus, physical reliability and/or electrical reliability may deteriorate. In addition, if the thickness of each layer of the insulating layer 110 exceeds 40 µm, an overall thickness of the circuit board 100 may increase, and accordingly, a thickness of the semiconductor package may increase. In addition, if the thickness of each layer of the insulating layer 110 exceeds 40 µm, it may be difficult to miniaturize the electrode part 120 and 130.

The circuit board 100 includes an electrode part. The electrode part may have a function of transmitting an electrical signal in the circuit board 100, but is not limited thereto. For example, the electrode part 120 and 130 may include a dummy electrode for improving rigidity or a heat dissipation electrode for improving heat dissipation characteristics.

The electrode part includes a first electrode part 120 disposed on a surface of the insulating layer 110. The first electrode part 120 is provided on an upper surface and/or lower surface of the insulating layer 110. When the insulating layer 110 is provided in multiple layers, the first electrode part 120 may be provided on each interface between the multiple layers of the insulating layer 110.

In addition, at least a portion of the first electrode part 120 disposed on an uppermost or lowermost side of the insulating layer 110 may be disposed in the insulating layer 110. For example, as illustrated in FIG. 1, at least a portion of the first electrode part 120 disposed at an uppermost side of the insulating layer 110 may be embedded in the insulating layer 110. Here, being embedded may mean that at least a portion of a side surface of the first electrode part 120 disposed at the uppermost side of the insulating layer 110 is covered with the insulating layer 110.

That is, a concave portion may be provided on an upper surface of the insulating layer 110 disposed at the uppermost side, and the first electrode part 120 disposed at the uppermost side may have an ETS (Embedded Trace Substrate) structure disposed within the concave portion of the insulating layer 110. The ETS structure is advantageous for miniaturization compared to an electrode part having a general protruding structure. Accordingly, the embodiment enables miniaturization of the first electrode part 120 disposed at the uppermost side of the circuit board 100 by having the ETS structure. At this time, the first electrode part 120 disposed at the uppermost side includes electrodes connected to terminals of the semiconductor device and an external substrate. Accordingly, the embodiment enables the formation of electrodes of the first electrode part 120 corresponding to a size and pitch of terminals provided in the semiconductor device. Through this, the embodiment can improve the circuit integration. Furthermore, the embodiment can minimize a transmission distance of a signal transmitted through the semiconductor device, thereby minimizing signal transmission loss.

The first electrode part 120 can be formed of at least one metal material selected from gold (Au), silver (Ag), platinum (Pt), titanium (Ti), tin (Sn), copper (Cu), and zinc (Zn). In addition, the first electrode part 120 can be formed of a paste or solder paste including at least one metal material selected from gold (Au), silver (Ag), platinum (Pt), titanium (Ti), tin (Sn), copper (Cu), and zinc (Zn) having excellent bonding strength. Preferably, the first electrode part 120 may be formed of copper (Cu) that has high electrical conductivity and is relatively inexpensive.

The first electrode part 120 may have a thickness in a range of 7 µm to 20 µm. For example, the first electrode part 120 may have a thickness in a range of 9 µm to 17 µm. For example, the first electrode part 120 may have a thickness in a range of 10 µm to 13 µm. If the thickness of the first electrode part 120 is less than 7 µm, a resistance of the first electrode part 120 may increase and an allowable current of a transmittable signal may decrease. In addition, if the thickness of the first electrode part 120 exceeds 20 µm, a thickness of the insulating layer 110 may increase correspondingly, making it difficult to thin the semiconductor package. In addition, if the thickness of the first electrode part 120 exceeds 20 µm, it may be difficult to miniaturize the first electrode part 120.

The first electrode part 120 includes a plurality of electrodes. Specifically, the first electrode part 120 disposed on the insulating layer 110 includes a plurality of electrodes.

For example, the first electrode part 120 disposed on the insulating layer 110 includes a first electrode 123, a second electrode 121, a third electrode 122, and a fourth electrode 124.

The first electrode 123, the second electrode 121, the third electrode 122, and the fourth electrode 124 are the first electrode part 120 disposed on a same plane, classified according to a placement position and/or function.

The second electrode 121, the third electrode 122, and the fourth electrode 124 of the first electrode part 120 refer to electrodes connected to terminals 225 of the semiconductor device 220. At this time, the semiconductor device 220 includes a terminal 225 provided on a lower surface. For example, the terminal 225 of the semiconductor device 220 may include first to third terminals. The second terminal of the semiconductor device 200 may be disposed in a circumference region of the lower surface of the semiconductor device 200. The third terminal of the semiconductor device 200 may be disposed in a center of the lower surface of the semiconductor device 200. The first terminal of the semiconductor device 200 may be disposed between the second terminal and the third terminal of the semiconductor device.

In addition, the second electrode 121 of the first electrode part 120 is connected to the first terminal of the semiconductor device 220. In addition, the third electrode 122 of the first electrode part 120 is connected to the second terminal of the semiconductor device 220. In addition, the fourth electrode 124 of the first electrode part 120 is connected to the third terminal of the semiconductor device 220. At this time, at least one of the second electrode 121, the third electrode 122, and the fourth electrode 124 may have a different width or shape from at least one other electrode. For example, terminals 225 of the semiconductor device 220 may have different sizes or pitches depending on an arrangement position. Accordingly, the second electrode 121, the third electrode 122, and the fourth electrode 124 may have a width or shape corresponding to the size or pitch of the terminal 225 of the semiconductor device 220. Through this, the embodiment can improve an integration degree of the first electrode part 120.

In addition, the first electrode 123 of the first electrode part 120 is an electrode connected to an external substrate 300. The external substrate 300 may be a substrate on which a semiconductor device 420 is disposed, or an interposer connected to a substrate on which a semiconductor device 420 is attached.

The first electrode 123 of the first electrode part 120 may have a width greater than that of the second electrode 121, the third electrode 122, and the fourth electrode 124.

In addition, the electrode part of the circuit board 100 further includes a second electrode part 130. The second electrode part 130 passes through at least a portion of a region of the insulating layer 110. The second electrode part 130 is provided between a plurality of first electrode parts 120 provided in different layers. The second electrode part 130 electrically connects a plurality of first electrode parts 120 provided in different layers along the vertical direction.

The second electrode part 130 can be formed by filling an inside of a through hole passing through at least a portion of a region of the insulating layer 110 with a conductive material.

A metal material forming the second electrode part 130 may be any one material selected from copper (Cu), silver (Ag), tin (Sn), gold (Au), nickel (Ni), and palladium (Pd). In addition, the filling of the conductive material may utilize any one of electroless plating, electrolytic plating, screen printing, sputtering, evaporation, ink-jetting, and dispensing, or a combination thereof.

The semiconductor package includes a protective layer disposed on at least one of the upper and lower portions of the insulating layer 110. For example, the semiconductor package includes an upper protective layer 140 disposed on the insulating layer 110. In addition, the semiconductor package includes a lower protective layer 150 disposed under the insulating layer 110.

The upper protective layer 140 and the lower protective layer 150 may have a function of protecting the insulating layer 110. The upper protective layer 140 and the lower protective layer 150 may be resist layers. Preferably, the upper protective layer 140 and the lower protective layer 150 may be solder resist layers including organic polymer materials. For example, the upper protective layer 140 and the lower protective layer 150 may include an epoxy acrylate series resin. In detail, the upper protective layer 140 and the lower protective layer 150 may include a resin, a curing agent, a photo initiator, a pigment, a solvent, a filler, an additive, an acrylic series monomer, and the like. However, the embodiment is not limited thereto, and the upper protective layer 140 and the lower protective layer 150 may of course be any one of a photo solder resist layer, a cover-lay, and a polymer material.

The upper protective layer 140 includes a first protective layer 141 including a through hole 141T1 and a second protective layer 142 disposed inside the through hole 141T1 of the first protective layer 141. The through hole 141T1 provided in the first protective layer 141 means a region where a semiconductor device 220 is disposed. Accordingly, the second protective layer 142 means an upper protective layer 140 disposed in a region that vertically overlaps the semiconductor device 220, and the first protective layer 141 means a protective layer surrounding the second protective layer 142. That is, the first protective layer 141 and the second protective layer 142 can be distinguished according to an arrangement position on the insulating layer 110. The first protective layer 141 and the second protective layer 142 may be divided into one configuration based on an arrangement position, or may mean a configuration that is different from each other or separated. Here, dividing one layer based on the arrangement position may mean that the first protective layer 141 and the second protective layer 142 are made of a same material.

At this time, an upper surface of the first protective layer 141 of the upper protective layer 140 has a step.

For example, the first protective layer 141 includes a first region (141R1, see FIG. 4) and a second region (141R2, see FIG. 4). The first region 141R1 of the first protective layer 141 means an inner region of an upper surface of the first protective layer 141. The inner region may mean a region adjacent to the through hole 141T of the first protective layer 141 and surrounding the through hole 141T. In addition, the inner region may mean a region that vertically overlaps with the semiconductor device 220. For example, the semiconductor device 200 placed on the circuit board 100 partially overlaps the first protective layer 141 in the vertical direction and the second protective layer 142 in the vertical direction as a whole. In addition, the first region 141R1 of the first protective layer 141 may mean a part of an entire region of the first protective layer 141 that vertically overlaps with the semiconductor device 220.

The second region 141R2 of the first protective layer 141 means a region other than the first region 141R1. The second region 141R2 of the first protective layer 141 may mean a circumference region of the upper surface of the first protective layer 141. The circumference region means a region adjacent to an edge or border of the upper surface of the first protective layer 141. In addition, the circumference region means a region that does not vertically overlap with a semiconductor device 220 disposed on a circuit board.

An upper surface 141R1 of the first region of the first protective layer 141 and an upper surface of the second region 141R2 of the first protective layer 141 have a step. A height of the upper surface of the first region 141R1 of the first protective layer 141 is different from a height of the upper surface of the second region 141R2. For example, the upper surface of the first region 141R1 is positioned lower than the upper surface of the second region 141R2.

The upper surface of the second protective layer 142 has a step difference from the upper surface of the first protective layer 141. For example, the upper surface of the second protective layer 142 has a step difference from the upper surface of the second region 141R2 of the first protective layer 141. The upper surface of the second protective layer 142 is positioned lower than the upper surface of the second region 141R2 of the first protective layer 141.

In addition, in one example, the upper surface of the second protective layer 142 does not have a step difference from the upper surface of the first region 141R1 of the first protective layer 141. For example, the upper surface of the second protective layer 142 may be positioned on a same plane as the upper surface of the first region 141R1 of the first protective layer 141.

In addition, the upper surface of the second protective layer 142 in another example has a step difference from the upper surface of the first region 141R1 of the first protective layer 141. For example, the upper surface of the second protective layer 142 may be positioned lower than the upper surface of the first region 141R1 of the first protective layer 141.

Through this, the embodiment may improve physical reliability of the conductive bonding part 160 provided in the circuit board 100.

That is, the semiconductor package includes a conductive bonding part 160. The conductive bonding part 160 is disposed on the first electrode 123 of the first electrode part 120 disposed on the insulating layer 110. The conductive bonding part 160 may mean an electrode that electrically connects the external substrate 300 and the first electrode 123. The conductive bonding part 160 may be referred to a post bump.

The conductive bonding part 160 passes through at least a portion of the second region 141R2 of the upper protective layer 140.

Therefore, the second region 141R2 of the first protective layer 141 is provided to surround a side surface of the conductive bonding part 160. In addition, the second region 141R2 of the first protective layer 141 can stably protect the conductive bonding part 160 from various factors that may occur in a manufacturing process of the semiconductor package. For example, in the embodiment, a side surface of the conductive bonding part 160 is entirely covered with the second region 141R2 of the first protective layer 141, and thus, the stress applied to the conductive bonding part 160 can be minimized compared to a conventional technology in which the side surface of the conductive bonding part 160 is covered with a plurality of insulating members of different materials.

In addition, the second region 141R2 of the first protective layer 141 has a step with the first region 141R1 of the first protective layer 141 and the second protective layer 142, and thus, the embodiment can provide ease of mounting process of the semiconductor device 220. For example, the step between the upper surface of the first region 141R1 of the first protective layer 141 and the upper surface of the second region 141R2 is provided at a position spaced apart from the semiconductor device 220 in the horizontal direction and surrounds the semiconductor device 220. The step between the upper surface of the first region 141R1 of the first protective layer 141 and the upper surface of the second region 141R2 does not overlap with the semiconductor device 220 in the vertical direction. Therefore, the step between the upper surface of the first region 141R1 of the first protective layer 141 and the upper surface of the second region 141R2 can define a molding region of the semiconductor device 220, thereby providing ease in a molding process of the semiconductor device 220.

Furthermore, the embodiment can improve a bonding strength with the semiconductor device.

The first protective layer 141 includes a plurality of open regions. For example, the first protective layer 141 includes an upper surface and a lower surface opposite to the upper surface. The first protective layer 141 includes a plurality of open regions that passes through the upper surface and the lower surface of the first protective layer 141 and are spaced apart from each other. The plurality of open regions of the first protective layer 141 are divided into through holes and openings. The division between the through holes and the openings can be made by a size, shape, and number of exposed electrodes.

For example, the first protective layer 141 includes a through hole (141T1, see FIG. 4). In addition, the first protective layer 141 includes a first opening (141T2, see FIG. 4) and a second opening (141T3, see FIG. 4) spaced apart from the through hole 141T1.

The through hole 141T1 of the first protective layer 141 may have a different planar shape from the first opening 141T2 and the second opening 141T3 of the first protective layer 141. The planar shape of the through hole 141T1 of the first protective layer 141 may correspond to a planar shape of the semiconductor device 220. For example, the planar shape of the through hole 141T1 of the first protective layer 141 may be a square shape, but is not limited thereto.

The first opening 141T2 and the second opening 141T3 of the first protective layer 141 may have a planar shape corresponding to a planar shape of each of the first electrode 123 and the third electrode 122 of the first electrode part 120. For example, the planar shape of the first opening 141T2 and the second opening 141T3 of the first protective layer 141 may be circular, but is not limited thereto.

A size of the through hole 141T1 of the first protective layer 141 is greater than the sizes of the first opening 141T2 and the second opening 141T3 of the first protective layer 141. The size may mean a planar area, or alternatively, may mean a width in a first horizontal direction and/or a second horizontal direction. The size of the through hole 141T1 of the first protective layer 141 is determined by a size of the semiconductor device 220. In addition, sizes of the first opening 141T2 and the second opening 141T3 of the first protective layer 141 are determined by a size of the conductive bonding part 160 and a size of the third electrode 122.

In addition, the through hole 141T1 of the first protective layer 141 vertically overlaps with the semiconductor device 220 mounted on the circuit board 100. The through hole 141T1 of the first protective layer 141 vertically overlaps with a plurality of electrodes that vertically overlap with the semiconductor device 220 among the first electrode parts 120 disposed on the insulating layer 110.

In addition, the first opening 141T2 of the first protective layer 141 overlaps vertically with the third electrode 122 of the first electrode part 120 of the circuit board 100. For example, the first opening 141T2 of the first protective layer 141 may partially overlap with the upper surface of one third electrode 122 in the vertical direction. In addition, the second opening 141T3 of the first protective layer 141 overlaps the first electrode 123 in the vertical direction. Preferably, the second opening 141T3 of the first protective layer 141 overlaps vertically with the conductive bonding part 160 provided on the first electrode 123. For example, the second opening 141T3 of the first protective layer 141 may partially overlap with the upper surface of the conductive bonding part 160 in the vertical direction.

The first opening 141T2 may refer to a region where the terminal 225 of the semiconductor device 220 and the electrodes of the first electrode part 120 are bonded, or may refer to a region where metal is disposed on the electrodes to bond the terminal 225 of the semiconductor device 220 and the electrodes of the first electrode part 120.

In addition, the second opening 141T3 may refer to a region where the external substrate 300 and the conductive bonding part 160 are bonded, or may refer to a region where metal is disposed on the conductive bonding part 160 to bond the external substrate 300 and the conductive bonding part 160.

In addition, the second protective layer 142 is disposed inside the through hole 141T1 of the first protective layer 141. For example, the second protective layer 142 is disposed on the upper surface of the insulating layer 110 in a region that vertically overlaps with the through hole 141T1 of the first protective layer 141. For example, the second protective layer 142 may be disposed in a region overlapping the semiconductor device 220 in the vertical direction.

The second protective layer 142 includes an opening 142T. The opening 142T of the second protective layer 142 overlaps the fourth electrode 124 of the first electrode part 120 in the vertical direction. For example, the opening 142T of the second protective layer 142 may partially overlap the upper surface of the fourth electrode 124 in the vertical direction.

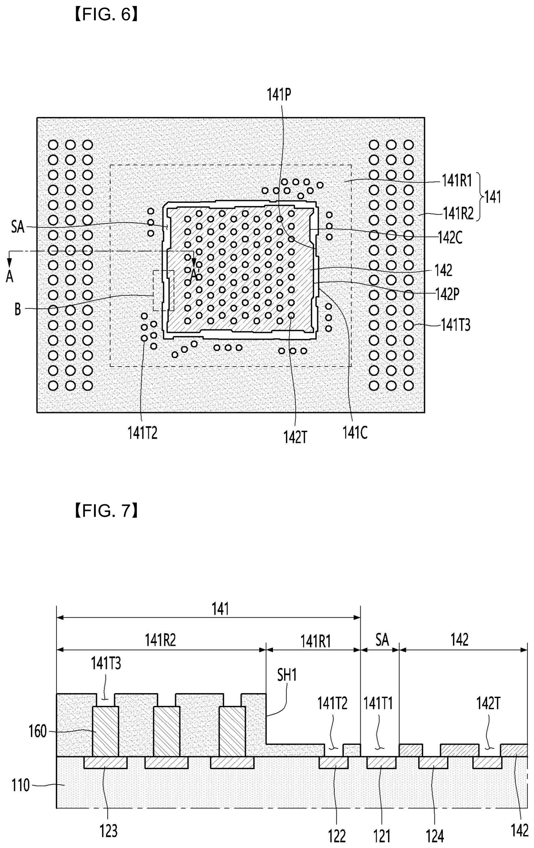

At this time, an area of the second protective layer 142 is smaller than an area of the through hole 141T1 of the first protective layer 141. Accordingly, when the second protective layer 142 is disposed inside the through hole 141T1 of the first protective layer 141, a separation region (SA, see FIG. 6) is provided between an inner surface of the through hole 141T1 of the first protective layer 141 and an outer surface of the second protective layer 142. The separation region SA refers to a region that overlaps the through hole 141T1 of the first protective layer 141 in the vertical direction but does not overlap the second protective layer 142 in the vertical direction. In addition, at least a part of the second electrode 121 of the first electrode part 120 of the circuit board 100 may overlap the separation region SA in the vertical direction.

Specific structures of the first protective layer 141 and the second protective layer 142 of the upper protective layer 140 will be described in more detail below.

Meanwhile, the lower protective layer 150 may include an opening. The opening of the lower protective layer 150 may overlap vertically with the electrodes of the first electrode part 120 disposed on the lower surface of the insulating layer 110 of the circuit board 100. The lower protective layer 150 may not include a through hole provided in the first protective layer 141 of the upper protective layer 140 and may only include an opening, but is not limited thereto.

In addition, a lower surface of the lower protective layer 150 may not have a step. However, the embodiment is not limited thereto. For example, the lower surface of the lower protective layer 150 may have a step corresponding to a step provided on the upper surface of the upper protective layer 140 described below.

Meanwhile, the semiconductor package includes a conductive bonding part 160. The conductive bonding part 160 is disposed on the first electrode 123 of the first electrode part 120 disposed on the insulating layer 110. The conductive bonding part 160 is an electrode that electrically connects between the external substrate 300 and the first electrode 123. The conductive bonding part 160 may be referred to as a post bump.

The conductive bonding part 160 passes through the upper protective layer 140. For example, the conductive bonding part 160 passes through at least a portion of a region of the first protective layer 141 of the upper protective layer 140.

The conductive bonding part 160 vertically overlaps with the second opening 141T3 of the first protective layer 141. Therefore, a side surface of the conductive bonding part 160 is surrounded by the first protective layer 141. A part of the upper surface of the conductive bonding part 160 is covered with the first protective layer 141. In addition, at least a part of the upper surface of the conductive bonding part 160 vertically overlaps with the second opening 141T3 of the first protective layer 141 and does not contact the first protective layer 141.

The conductive bonding part 160 may be provided to reduce a volume of the second contacting part 240 for bonding with the external substrate 300 while spacing the external substrate 300 apart from the circuit board 100 by a certain distance.

In addition, the semiconductor package includes the first contacting part 210. For example, the first contacting part 210 is disposed on the electrodes of the first electrode part 120 that are connected to the terminal 225 of the semiconductor device 220. Specifically, the first contacting part 210 is disposed on the second electrode 121, the third electrode 122, and the fourth electrode 124 of the first electrode part 120 that are disposed on the insulating layer 110.

The first contacting part 210 is disposed in the first opening 141T2 of the first protective layer 141, the opening 141T2 of the second protective layer 142, and the separation region SA between the first protective layer 141 and the second protective layer 142, respectively.

The first contacting part 210 may mean a metal that electrically connects a plurality of components using at least one bonding method among wire bonding, solder bonding, and direct bonding between metals. Since the first contacting part 210 has the function of electrically connecting multiple components, when direct bonding between metals is used, the first contacting part can be understood as a part that is electrically connected, not a solder or wire.

The wire bonding method can mean electrically connecting multiple components using a conductor such as gold (Au). In addition, the solder bonding method can electrically connect multiple components using a material including at least one of Sn, Ag, and Cu. In addition, the direct bonding method between metals can mean directly bonding between multiple components by applying heat and pressure between multiple components without the absence of solder, wire, or conductive adhesive. In this case, the first contacting part 210 can mean a metal layer formed between multiple components by recrystallization.

For example, the first contacting part 210 can bond multiple components to each other by a thermal compression bonding method. The thermal compression bonding method may mean a method of directly bonding a plurality of components by applying heat and pressure to the first contacting part 210.

The semiconductor package of the embodiment includes a semiconductor device 220 disposed on the first contacting part 210. A terminal 225 is provided on the lower surface of the semiconductor device 220. The terminal 225 of the semiconductor device 220 is electrically connected to the second electrode 121, the third electrode 122, and the fourth electrode 124 of the first electrode part 120 through the first contacting part 210.

The semiconductor package may include an underfill 230. The underfill 230 is disposed on the circuit board 100. The underfill 230 is disposed to cover a periphery of the semiconductor device 220 on the circuit board 100. The underfill 230 may be disposed on a portion of the upper surface of the first protective layer 141 and a portion of the upper surface of the second protective layer 142. In addition, the underfill 230 may be disposed in a portion of the open region of the first protective layer 141, and a portion of the open region of the second protective layer 142.

The semiconductor package includes a second contacting part 240. The second contacting part 240 is disposed on the conductive bonding part 160. For example, the second contacting part 240 is disposed in the second opening 141T3 of the first protective layer 141 that vertically overlaps the conductive bonding part 160.

At this time, an upper surface of the second contacting part 240 is positioned higher than an upper surface of the semiconductor device 220. In addition, a lower surface of the second contacting part 240 is positioned lower than an upper surface of the semiconductor device 220 and higher than a lower surface of the semiconductor device 220. That is, the upper surface of the conductive bonding part 160 bonded to the second contacting part 240 is positioned lower than the upper surface of the semiconductor device 220. In addition, the lower surface of the conductive bonding part 160 is positioned higher than the lower surface of the semiconductor device 220. Through this, the embodiment can prevent the semiconductor device 220 from being damaged during a bonding process of the external substrate 300 disposed on the second contacting part 240. Furthermore, the embodiment can reduce a volume of the second contacting part 240 by using the conductive bonding part 160. Through this, the embodiment can secure the rigidity of the conductive bonding part 160 and the second contacting part 240. Therefore, the embodiment can improve physical reliability and/or electrical reliability of the semiconductor package. In addition, the embodiment can stably bond the external substrate 300 on the conductive bonding part 160 and the second contacting part 240.

At this time, the semiconductor package of the first embodiment of FIG. 1 may have a package-on-package structure. That is, the semiconductor package may have a structure in which a plurality of packages are disposed in a vertical direction and the plurality of packages are electrically connected along the vertical direction, but is not limited thereto.

The semiconductor package includes a molding layer 250.

The molding layer 250 is disposed between the circuit board 100 and the external substrate 300. The molding layer 250 is disposed on the upper protective layer 140. The molding layer 250 molds the second contacting part 240, the underfill 230, and the semiconductor device 220.

The molding layer 250 is disposed on the first protective layer 141 and the second protective layer 142 of the upper protective layer 140. At this time, the upper surface of the first protective layer 141 of the upper protective layer 140 has a step. Accordingly, a lower surface of the molding layer 250 has a step corresponding to the step of the upper surface of the upper protective layer 140.

The semiconductor package includes a third contacting part 260.

The third contacting part 260 is disposed on the lower surface of the first electrode part 120 disposed on the lower surface of the insulating layer 110. For example, the third contacting part 260 may be disposed in an opening of the lower protective layer 150. The third contacting part 260 may be a solder for connecting the semiconductor package of the embodiment to a separate external substrate (e.g., a main board of an electronic device), but is not limited thereto.

The semiconductor package includes an external substrate 300. The external substrate 300 may mean a separate substrate coupled with the circuit board 100. For example, the semiconductor device 220 disposed on the circuit board 100 may be a logic chip such as a CPU or GPU, and the external substrate 300 may mean a memory substrate on which a memory chip connected to the logic chip is disposed. The external substrate 300 may be an interposer connecting between the memory substrate on which the semiconductor device 420 corresponding to the memory chip is disposed and the circuit board 100.

The external substrate 300 may include an insulating layer 310, a circuit layer 320, and a through electrode 330. The semiconductor package may include an upper insulating layer 340 disposed on an upper surface of the external substrate 300 and a lower insulating layer 350 disposed on a lower surface of the external substrate 300.

The semiconductor package includes a fourth contacting part 410 and a semiconductor device 420. The semiconductor device 420 may be mounted on an external substrate 300 via the fourth contacting part 410. The semiconductor device 420 may be a memory chip, but is not limited thereto.

Meanwhile, referring to FIG. 2, the semiconductor package of the second embodiment may be different from the semiconductor package of the first embodiment in a structure of the circuit board 100.

For example, the semiconductor package of the first embodiment includes a core-less substrate, and the semiconductor package of the second embodiment of FIG. 2 includes a core substrate.

Referring to FIG. 2, the circuit board 100 includes an insulating layer 110. The insulating layer 110 has a multi-layer structure. The insulating layer 110 includes a first insulating layer 111 including a reinforcing member. The reinforcing member provided in the first insulating layer 111 may mean glass fiber.

The insulating layer 110 includes a second insulating layer 112 disposed on upper and lower sides of the first insulating layer 111, respectively. The second insulating layer 112 may not include a reinforcing member, unlike the first insulating layer 111. For example, the second insulating layer 112 may be ABF, but is not limited thereto.

In addition, the semiconductor package of the second embodiment has a structure in which the first electrode part 120 disposed at an uppermost side of the insulating layer 110 protrudes on the insulating layer 110.

Meanwhile, referring to FIG. 3, the semiconductor package includes a connection member 500 embedded in the insulating layer 110. The connection member 500 is disposed in the insulating layer 110 of the circuit board 100 and horizontally connects a plurality of semiconductor devices mounted on the circuit board 100 through the connection member 500. At this time, the insulating layer 110 may have a cavity 110C, and the connection member 500 may be embedded in the cavity 110C of the insulating layer 110.

The connection member 500 has high-density electrode patterns. The connection member 500 may be an organic bridge or an inorganic bridge.

The connection member 500 includes a connection electrode 510. The connection electrode 510 may mean an electrode disposed at an uppermost side of the connection member 500, and may mean an electrode connected to the electrodes of the first electrode part 120 of the circuit board 100.

A fourth contacting part 520 is disposed between the connection electrode 510 of the connection member 500 and the electrodes of the first electrode part 120 of the circuit board 100. The fourth contacting part 520 electrically connects the connection electrode 510 of the connection member 500 and the electrodes of the first electrode part 120 of the circuit board 100.

In addition, a plurality of semiconductor devices are mounted on the electrodes of the first electrode part 120. For example, a first semiconductor device 220 and a second semiconductor device 270 are mounted on the electrodes of the first electrode part 120. The first semiconductor device 220 and the second semiconductor device 270 are horizontally spaced apart from each other on the circuit board 100. The first semiconductor device 220 includes a first terminal 225, and the second semiconductor device 270 includes a second terminal 275. In addition, at least a part of the first terminal 225 of the first semiconductor device 220 and at least a part of the second terminal 275 of the second semiconductor device 270 overlap with the connection member 500 in the vertical direction. Therefore, at least a part of the first terminal 225 of the first semiconductor device 220 and at least a part of the second terminal 275 of the second semiconductor device 270 are electrically connected to each other through the connection member 500.

Meanwhile, a second contacting part 240 is disposed on the conductive bonding part 160, and a third semiconductor device 280 is coupled to the second contacting part 240. The third semiconductor device 280 includes a plurality of terminals 285. Some of the plurality of terminals of the third semiconductor device 280 are coupled to the conductive bonding part 160 through the second contacting part 240. In addition, some of other terminals of the third semiconductor device 280 are electrically connected to the first semiconductor device 220 through the fifth contacting part 241. In addition, some of other terminals of the third electrode 122 are electrically connected to the second semiconductor device 270 through the sixth contacting part 242.

At this time, the third semiconductor device 280 can receive a power signal and/or electric power through the conductive bonding part 160. In addition, the third semiconductor device 280 can exchange communication signals with the first and second semiconductor devices 220 and 270 through the fifth contacting part 241 and the sixth contacting part 242, or can horizontally electrically connect the first and second semiconductor devices 220 and 270.

The semiconductor package of the third embodiment may have a function of providing sufficient power for driving the third semiconductor device 280, smoothly controlling power operation, and suppressing noise by reducing interference between signals when connecting signals of the first to third semiconductor devices 220, 270, and 280 by supplying a power signal and/or power to the third semiconductor device 280 through the conductive bonding part 160.

Hereinafter, a structure of the electrodes of the first electrode part 120 of the circuit board 100 of the embodiment, a step structure of the upper protective layer 140, and an open structure of the upper protective layer 140 will be described in detail.

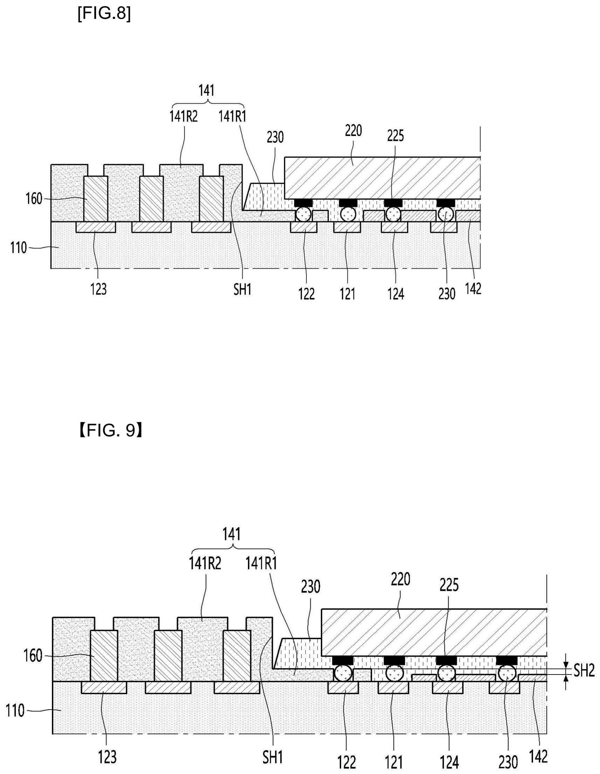

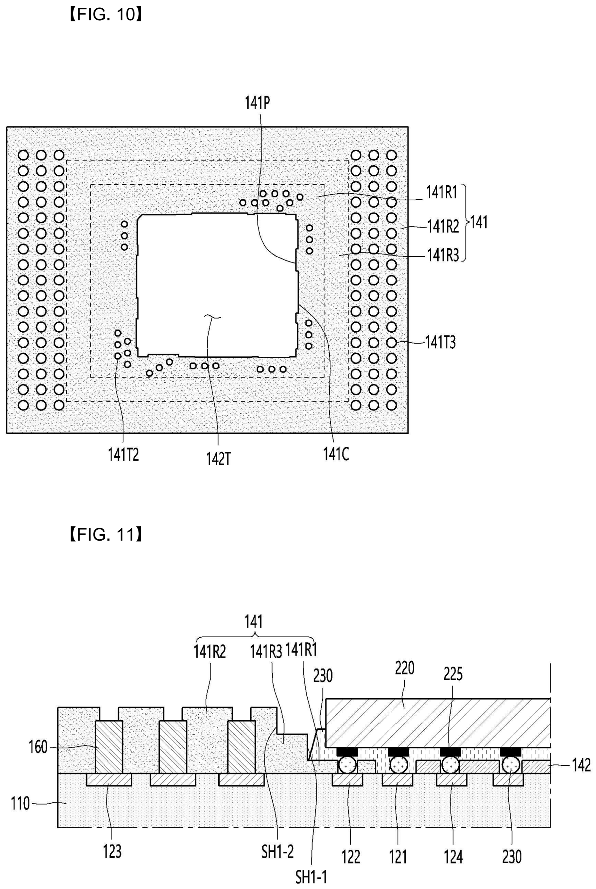

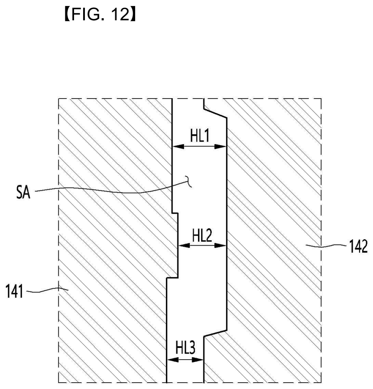

FIG. 4 is a plan view of a first protective layer according to a first embodiment, FIG. 5 is a plan view of a second protective layer according to an embodiment, FIG. 6 is a plan view showing a state in which a second protective layer is disposed in a through hole of a first protective layer according to an embodiment, FIG. 7 is a cross-sectional view of one embodiment taken along direction A-A' of FIG. 6, FIG. 8 is a cross-sectional view showing a state in which a semiconductor device is disposed in a semiconductor package of FIG. 7, FIG. 9 is a cross-sectional view of another embodiment cut taken direction A-A' of FIG. 6, FIG. 10 is a plan view of a first protective layer according to a second embodiment, FIG. 11 is a cross-sectional view showing a state in which a semiconductor device is disposed in a semiconductor package including the first protective layer of FIG. 10, and FIG. 12 is an enlarged view of region B of FIG. 6

Referring to FIGS. 4, 5, and 6, the first protective layer 141 is disposed on the insulating layer 110.

The first protective layer 141 includes an open region. The first protective layer 141 includes a plurality of open regions of a through hole type passing through the upper surface of the first protective layer and the lower surface of the first protective layer.

The first protective layer 141 includes a through hole 141T1 that vertically overlaps a semiconductor device 220 mounted on the insulating layer 110. A shape and a size of the through hole 141T1 of the first protective layer 141 may correspond to a shape and a size of the semiconductor device 220, but are not limited thereto.

A planar area of the through hole 141T1 of the first protective layer 141 may correspond to a planar area of the semiconductor device 220. For example, the planar area of the through hole 141T1 of the first protective layer 141 may be 60% or more, 70% or more, or 80% or more of the planar area of the semiconductor device 220. In addition, the planar area of the through hole 141T1 of the first protective layer 141 is smaller than the planar area of the semiconductor device 220. Therefore, at least a portion of the upper surface of the first protective layer 141 overlaps the semiconductor device 220 in the vertical direction.

An upper surface of the first protective layer 141 has a step along the horizontal direction in a region where the through hole 141T1 is provided. That is, the upper surface of the first protective layer 141 includes an inner edge portion 141P and 141C to define the through hole 141T1. The inner edge portion 141P and 141C has a step along the horizontal direction. For example, the inner edge portion 141P and 141C may be divided into a protruding surface 141P and a concave surface 141C having a step along the horizontal direction.

In one embodiment, the protruding surface 141P and the concave surface 141C may be provided on an upper surface of the first protective layer 141 connected to an inner surface of the through hole 141T1 or on an edge portion of the inner surface of the through hole 141T.

An inner surface constituting the through hole 141T1 of the first protective layer 141 has a step in the horizontal direction. For example, the inner surface of the through hole 141T1 of the first protective layer 141 includes a protruding surface 141P protruding in a direction away from the inner surface. For example, the inner surface of the through hole 141T1 of the first protective layer 141 includes a concave surface 141C recessed in a direction toward an inner side of the first protective layer 141.

At this time, an outer surface of the first protective layer 141 does not have a step in the horizontal direction. Accordingly, a fact that the inner surface of the through hole 141T1 of the first protective layer 141 has a step may mean that a horizontal distance between the outer surface and the inner surface of the first protective layer 141 that correspond to each other is different along a circumference of the inner surface of the first protective layer 141.

In addition, although the protruding surface 141P and the concave surface 141C are described as protruding or recessed in the horizontal direction along the circumferential direction of the inner surface of the through hole 141T1 of the first protective layer 141, but are not limited thereto.

In addition, the through hole 141T1 of the first protective layer 141 overlaps the semiconductor device 220 in the vertical direction. Therefore, the through hole 141T of the first protective layer 141 overlaps a plurality of electrodes of the first electrode part 120 of the circuit board 100, which are connected to the terminal 225 of the semiconductor device 220, in the vertical direction.

For example, the first electrode part 120 disposed on the insulating layer 110 includes a plurality of first electrodes 123, a plurality of second electrodes 121, a plurality of third electrodes 122, and a plurality of fourth electrodes 124. In addition, the through hole 141T1 provided in the first protective layer 141 overlaps a plurality of second electrodes 121 and a plurality of fourth electrodes 124 in the vertical direction. The through hole 141T1 of the first protective layer 141 means one hole, and accordingly, the through hole 141T1 commonly overlaps the plurality of second electrodes, the plurality of fourth electrodes, and the traces disposed between the plurality of second electrodes and the plurality of fourth electrodes in the vertical direction.

The first protective layer 141 includes a plurality of openings.

The first protective layer 141 includes a plurality of first openings 141T2 and a plurality of second openings 141T3. The first opening 141T2, the second opening 141T3, and the through hole 141T1 are substantially the same in that they passes through the first protective layer 141, but can be distinguished from each other by at least one of their positions, sizes, and shapes.

The first protective layer 141 includes a plurality of first openings 141T2. A plurality of first openings 141T2 can passes through the first protective layer 141 in a region adjacent to the through hole 141T1. The first opening 141T2 is not connected to the through hole 141T1. For example, the first opening 141T2 passes through the first protective layer 141 at a position spaced apart from the through hole 141T1. However, the embodiment is not limited thereto. For example, the first opening 141T2 may be provided in plurality, and any one of the plurality of first openings may be connected to the through hole 141T1.

The first opening 141T2 may be provided adjacent to a plurality of inner surfaces forming the through hole 141T1 of the first protective layer 141. For example, the first opening 141T2 may be provided adjacent to each of first to fourth inner side surfaces of the first through hole 141T1 of the first protective layer 141. A size and/or a shape of the first opening 141T2 may correspond to a size and/or a shape of the third electrode 122 of the circuit board 100.

At this time, the first opening 141T2 may partially overlap with the upper surface of the third electrode 122 in a vertical direction. For example, a part of the upper surface of the third electrode 122 may overlap with the first opening 141T2 of the first protective layer 141 in a vertical direction, and a remaining part of the third electrode 122 may be covered with the first protective layer 141. For example, the first opening 141T2 of the first protective layer 141 may be an opening of a SMD (Solder Mask Defined) type, but is not limited thereto. For example, the first opening 141T2 of the first protective layer 141 may be an opening of a NSMD (Non-solder Mask Defined) type.

The first protective layer 141 may further include a second opening 141T3. The second opening 141T3 of the first protective layer 141 may passes through the first protective layer 141 at a position spaced apart from the through hole 141T1 and the first opening 141T2.

Preferably, the second opening 141T3 of the first protective layer 141 may be provided in an outer region of the upper surface of the first protective layer 141.

For example, the second opening 141T3 of the first protective layer 141 may be provided in a circumference region of the upper surface of the first protective layer 141. Preferably, the second opening 141T3 of the first protective layer 141 is provided in a region overlapping the conductive bonding part 160 in the vertical direction.

A width of the second opening 141T3 of the first protective layer 141 may be greater than a width of the first opening 141T2. For example, a width of the third electrode 122 of the first electrode part 120 may be smaller than a width of the first electrode 123. In addition, a width of the conductive bonding part 160 disposed on the first electrode 123 may be greater than a width of the third electrode 122. Therefore, a width of the second opening 141T3 of the first protective layer 141 may be greater than a width of the first opening 141T2 of the first protective layer 141.

The through hole 141T1 of the first protective layer 141 can be said to be a region where the second protective layer 142, the semiconductor device 220, and the first contacting part 210 are disposed. In addition, the first opening 141T2 of the first protective layer 141 can be said to be a region where the first contacting part 210 is disposed. In addition, the second opening 141T3 of the first protective layer 141 can be said to be a region where the second contacting part 240 is disposed.

In addition, the second protective layer 142 includes a plurality of openings 142T. The plurality of openings 142T of the second protective layer 142 overlap with the through hole 141T1 of the first protective layer 141 in the vertical direction. The plurality of openings 142T of the second protective layer 142 vertically overlap with the plurality of fourth electrodes 124 of the first electrode part 120 disposed on the insulating layer 110, respectively.

The opening 142T of the second protective layer 142 may partially overlap with the upper surface of the fourth electrode 124 in the vertical direction. For example, a part of the upper surface of the fourth electrode 124 may vertically overlap with the opening 142T of the second protective layer 142, and the remaining part of the fourth electrode 124 may be covered with the second protective layer 142. For example, the opening 142T of the second protective layer 142 may be an opening of a SMD (Solder Mask Defined) type, but is not limited thereto. For example, the opening 142T of the second protective layer 142 may also be an opening of a NSMD (Non-solder Mask Defined) type.

In one embodiment, the upper surface of the second protective layer 142 is positioned on a same plane as a part of the upper surface of the first protective layer 141, as shown in FIGS. 7 and 8. For example, the upper surface of the second protective layer 142 is positioned on a same plane as the upper surface of the first region 141R1 of the first protective layer 141.

In addition, in another embodiment, the upper surface of the second protective layer 142 is positioned lower than the upper surface of the first region 141R1 of the first protective layer 141, as shown in FIG. 9. For example, a step SH2 may be provided between the upper surface of the second protective layer 142 and the upper surface of the first region 141R1 of the first protective layer 141, but is not limited thereto.

That is, the second protective layer 142 may be disposed only on the insulating layer 110 in a region between the plurality of fourth electrodes 124. For example, the second protective layer 142 may not vertically overlap with the plurality of electrodes disposed on the upper surface of the insulating layer 110 of the circuit board 100.

An outer surface of the second protective layer 142 may include at least one of a protruding surface 142P and a concave surface 142c. For example, when the outer surface of the second protective layer 142 includes a protruding surface 142P, a remaining outer surface except for the protruding surface 142P may also be referred to as a concave surface. For example, when the outer surface of the second protective layer 142 includes a concave surface, a remaining outer surface except for the concave surface 142c may be referred to as a protruding surface.

The outer surface of the second protective layer 142 may face the inner surface of the first protective layer 141 in a horizontal direction.

At this time, a part of the protruding surface 141P of the inner surface of the first protective layer 141 may overlap a part of the protruding surface 142P of the outer surface of the second protective layer 142 in a horizontal direction, and a remaining part of the protruding surface 141P of the inner surface of the first protective layer 141 may overlap a part of the concave surface 142c of the outer surface of the second protective layer 142 in a horizontal direction.

In addition, a part of the concave surface 141C of the inner surface of the first protective layer 141 may overlap a part of the protruding surface 142P of the outer surface of the second protective layer 142 in a horizontal direction, and a remaining part of the concave surface 141C of the inner surface of the first protective layer 141 may overlap a part of the concave surface 142c of the outer surface of the second protective layer 142 in a horizontal direction

In addition, a planar area of the through hole 141T1 of the first protective layer 141 is greater than a planar area of the second protective layer 142. In addition, the first protective layer 141 does not contact the second protective layer 142.

Therefore, in a state where the second protective layer 142 is disposed inside the through hole 141T1 of the first protective layer 141, a separation region SA is provided between an inner surface forming the through hole 141T1 of the first protective layer 141 and an outer surface of the second protective layer 142.

The separation region SA may mean a partial region of an entire region of the through hole 141T1 of the first protective layer that does not overlap with the second protective layer 142 in the vertical direction 141. Accordingly, the separation region SA can be formed in a closed loop shape between the inner surface of the first protective layer 141 and the outer surface of the second protective layer 142. Accordingly, the embodiment can prevent electrical short circuit between the first electrode part 120 located in a region adjacent to the separation region SA. In addition, the separation region SA can serve as an alignment key for arranging the semiconductor device, thereby improving the process yield. In addition, the first protective layer 141 and the second protective layer 142 can have a structure physically separated from each other, the embodiment may control the stress applied to the circuit board 100, thereby improving the mechanical reliability of the semiconductor device package.

In addition, the upper surface of the first protective layer 141 has a step. For example, the upper surface of the first protective layer 141 has a step in the vertical direction. For example, an upper surface of one region of the first protective layer 141 is located higher than an upper surface of another region of the first protective layer 141.

That is, referring to FIG. 4, FIG. 7, and FIG. 8, the first protective layer 141 includes a first region 141R1 and a second region 141R2. The first region 141R1 of the first protective layer 141 is an inner region of the upper surface of the first protective layer 141 that vertically overlaps the semiconductor device 220, and the second region 141R2 of the first protective layer 141 is a region other than the first region 141R1. For example, the second region 141R2 of the first protective layer 141 may be a circumferential region adjacent to a border or edge of the upper surface of the first protective layer 141.

The circumferential region means a region that is provided along a circumferential direction of the upper surface of the first protective layer 141 and is adjacent to a circumference of the upper surface. In addition, the inner region means a region other than the circumferential region. For example, the circumferential region may be a region adjacent to the circumference of the upper surface of the first protective layer 141, and the inner region may mean a region adjacent to the inner surface of the through hole 141T1.

For example, the first protective layer 141 includes a second region 141R2 including a second opening 141T3 and corresponding to a circumferential region of the upper surface of the first protective layer 141. In addition, the first protective layer 141 includes a first region 141R1 including a first opening 141T2 and corresponding to an inner region of the first region 141R1 of the first protective layer 141.

At this time, the second region 141R2 of the first protective layer 141 is provided to surround the circumference of the conductive bonding part 160 disposed on the first electrode 123. The second region 141R2 of the first protective layer 141 has a first height. For example, the upper surface of the second region 141R2 of the first protective layer 141 is positioned higher than the upper surface of the conductive bonding part 160.

That is, the side surface of the conductive bonding part 160 of the embodiment is entirely covered with the first protective layer 141. Accordingly, the embodiment does not need to form a separate molding member covering the side surface of the conductive bonding part 160, thereby simplifying a manufacturing process.

Furthermore, the embodiment allows the side surface of the conductive bonding part 160 to be entirely covered by the first protective layer 141. Accordingly, the stress acting on the conductive bonding part 160 may be minimized, and accordingly, the embodiment may solve the reliability problem that cracks occur at an interface between the conductive bonding part 160 and the first electrode 123 due to the concentration of stress on the conductive bonding part 160.

For example, according to a conventional technology, a part of the side surface of the conductive bonding part is covered with a protective layer, and the remaining part of the side surface of the conductive bonding part is covered with a molding member. At this time, the protective layer and the molding member include different insulating materials, and thus have different thermal expansion coefficients. Therefore, one of the protective layer and the molding member may expand or contract more than the other. Therefore, different stresses may be applied to a side surface of the conductive bonding part contacting the molding member and a side surface of the conductive bonding part contacting the protective layer, and thus the physical reliability of the conductive bonding part may be deteriorated.

In addition, according to another conventional technology, a side surface of the conductive bonding part may be entirely in contact with the molding member. At this time, the molding member is laminated after the semiconductor device is mounted on the circuit board. Therefore, the upper surface and the side surface of the conductive bonding part may be entirely exposed in a process of mounting the semiconductor device. Therefore, in a process of mounting the semiconductor device, a physical impact may be applied to the conductive bonding part, and as a result, the conductive bonding part may be peeled off from the first electrode part 120. In addition, in the process of mounting the semiconductor device, foreign substances may accumulate on the upper surface of the conductive bonding part, and as a result, the electrical reliability of the conductive bonding part may be deteriorated.

In contrast, in the embodiment, the second region 141R2 of the first protective layer 141 is provided to completely surround the side surface of the conductive bonding part 160. Through this, the embodiment can allow a uniform stress to be applied to the entire region of the conductive bonding part 160 according to the expansion or contraction of the first protective layer 141, and thus, the physical reliability problem of the conductive bonding part 160 being peeled off from the first electrode 123 can be solved.

In addition, the embodiment can stably protect the conductive bonding part 160 from impact applied in a process of mounting a semiconductor device, and thus improve the physical reliability and/or electrical reliability of the conductive bonding part 160.

The second region 141R2 of the first protective layer 141 is provided along the circumferential direction of the upper surface of the first protective layer 141. In addition, the first region 141R1 of the first protective layer 141 are provided at an inner side of the second region 141R2. At this time, the first region 141R1 of the first protective layer 141 has a height lower than that of the second region 141R2.

Therefore, the second region 141R2 of the first protective layer 141 is provided to have a greater height than the first region 141R1 while surrounding an outer side of the first region 141R1. Preferably, a first step (SH1, see FIG. 7) is provided between the upper surface of the first region 141R1 of the first protective layer 141 and the upper surface of the second region 141R2.

Through this, the second region 141R2 of the first protective layer 141 can function as a dam in a process of applying the first contacting part 210 in a mounting process of the semiconductor device. For example, the first contacting part 210 is applied within the first opening 141T2 provided in the first region 141R1 of the first protective layer 141. At this time, the second region 141R2 of the first protective layer 141 can have a dam structure with a height greater than that of the first region 141R1 while surrounding the first region 141R1. Therefore, the second region 141R2 of the first protective layer 141 can facilitate the first contacting part 210 to be easily disposed at a desired position in a process of applying the first contacting part 210 within the first opening 141T2. Through this, the embodiment can provide ease of a manufacturing process of the semiconductor package and further improve the product yield.

In addition, the second region 141R2 of the first protective layer 141 can also function as a dam that prevents overflow of the underfill 230 disposed around the semiconductor device 220 disposed in the first region 141R1.

In addition, a fact that the upper surfaces of the first region 141R1 and the second region 141R2 of the first protective layer 141 have a step means that thicknesses of the first region 141R1 and the second region 141R2 are different from each other.

For example, the thickness of the first region 141R1 of the first protective layer 141 is smaller than the thickness of the second region 141R2.

At this time, a difference in thickness may mean that a number of layers in the first region 141R1 of the first protective layer 141 is smaller than a number of layers in the second region 141R2, but is not limited thereto. For example, the first protective layer 141 may have a layer structure of one layer in the first region 141R1, and may have a layer structure of two or more layers in the second region 141R2.

In addition, although the first protective layer 141 is described as including the first region 141R1 and the second region 141R2, but the embodiment is not limited thereto.

For example, referring to FIG. 10 and FIG. 11, the upper surface of the first protective layer 141 may have at least two or more steps.

For example, the first protective layer 141 includes a first region 141R1 and a second region 141R2. In addition, the first protective layer 141 further includes a third region 141R3 between the first region 141R1 and the second region 141R2. The third region 141R3 of the first protective layer 141 has a step with respect to the first region 141R1 and the second region 141R2. For example, the first protective layer 141 may include a first step SH1-1 between the first region 141R1 and the third region 141R3, and a second step SH1-2 between the second region 141R2 and the third region 141R3. For example, an upper surface of the third region 141R3 of the first protective layer 141 is positioned higher than an upper surface of the first region 141R1. In addition, the upper surface of the third region 141R3 of the first protective layer 141 is positioned lower than an upper surface of the second region 141R2. Through this, the embodiment can enable the underfill 230 to be formed only at a desired position, thereby reducing a volume of the underfill 230, and thus reducing a manufacturing cost. Furthermore, the embodiment can provide the first step SH1-1 adjacent to a region where the semiconductor device 220 is disposed, thereby serving as an alignment mark for attaching the semiconductor device 220 at a desired position. Through this, the embodiment can further simplify a mounting process of the semiconductor device 220, and thereby further improve the process yield.

Also, referring to FIG. 12, a separation distance in a horizontal direction between the first protective layer 141 and the second protective layer 142 may include at least two different first separation distances and second separation distances along the circumference of the outer surface of the second protective layer 142. The separation distance may mean a separation distance in a first horizontal direction between the outer surface of the second protective layer 142 and the inner surface of the first protective layer 141 along the circumference of the outer surface of the second protective layer 142 and/or a separation distance in a second horizontal direction perpendicular to the first horizontal direction. The first horizontal direction may mean any one of a lateral direction, a x-axis direction, and a width direction. In addition, the second horizontal direction may mean any one of a longitudinal direction, a y-axis direction, and a length direction perpendicular to the first horizontal direction.

That is, a spacing in a horizontal direction between the inner surface of the through hole 141T1 of the first protective layer 141 and the outer surface of the second protective layer 142 may include different spacings along the inner surface of the through hole 141T1.

At this time, the separation distance and the spacing may have a same meaning.

For example, as illustrated in FIG. 12, the separation distance may include a first separation distance HL1 and a second separation distance HL2. Furthermore, the separation distance may further include a third separation distance HL3.

Specifically, the inner surface constituting the through hole 141T1 of the first protective layer 141 includes a protruding surface 141P and a concave surface 141C. In addition, the outer surface of the second protective layer 142 may also include a protruding surface 142P and a concave surface 142c.

In addition, the first separation distance HL1, the second separation distance HL2, and the third separation distance HL3 may be different from each other.

For example, the first separation distance HL1 may be greater than the second separation distance HL2, and the second separation distance HL2 may be greater than the third separation distance HL3. For example, the first separation distance HL1 may be a largest distance and the third separation distance HL3 may be a smallest distance among the first separation distance HL1, second separation distance HL2, and third separation distance HL3.

The first separation distance HL1 means a distance in a horizontal direction of a region where the concave surface 141C of the inner surface of the first protective layer 141 and the concave surface 142C of the outer surface of the second protective layer 142 horizontally face each other in the separation region SA.

The second separation distance HL2 means a distance in a horizontal direction of a region where the protrusion surface 141P of the inner surface of the first protective layer 141 and the concave surface 142C of the outer surface of the second protective layer 142 horizontally face each other in the separation region SA.

The third separation distance HL3 means a distance in a horizontal direction of a region where the concave surface 141C of the inner surface of the first protective layer 141 and the protrusion surface 142P of the outer surface of the second protective layer 142 horizontally face each other in the separation region SA.

In this case, a difference between the first separation distance HL1, the second separation distance HL2, and the third separation distance HL3 of the separation region SA may be due to an arrangement structure of the second electrode 121 disposed in the separation region SA.

For example, the first electrodes 121 are disposed in a first separation region (e.g., a region corresponding to the first separation distance HL1) of the separation region SA in a greater number than other separation regions, or, alternatively traces connected to the second electrode 121 may be intensively disposed in the first separation region.

In addition, the second electrode 121 and/or the trace may be disposed in a second separation region of the separation region SA (e.g., a region corresponding to the second separation distance HL2) with an integration density lower than that of the first separation region.

Here, integration density may mean a ratio of an area occupied by electrodes or traces of the first electrode part 120 in a certain area. For example, if a ratio of an area occupied by the electrode or trace in a certain unit area of the insulating layer 110 is relatively high, this may mean that the integration density is high.

In addition, the second electrode 121 and/or the trace may be disposed in a third separation region of the separation region SA (e.g., a region corresponding to the third separation distance HL3) with an integration density lower than that of the first separation region and the second separation region.

In other words, a separation distance between the first electrodes and/or traces disposed in the first separation region may be smaller than a separation distance between the first electrodes and/or traces disposed in the second separation region and the third separation region.

That is, the first electrodes or traces, which must have no mutual signal interference or a small mutual signal transmission distance, are intensively disposed in the first separation region. In addition, the embodiment arranges a second electrode and/or a trace that requires a certain separation distance due to mutual signal interference in the second or third separation region. Accordingly, the embodiment can improve the electrical reliability of the semiconductor package, thereby improving the electrical signal characteristics.

In this case, the second electrode 121 and the trace may be disposed in the first to third separation regions with the same integration density, but a distance between the first electrodes to be connected to each other may increase in this structure, and thus signal transmission loss may increase. Furthermore, when the second electrode 121 and the trace are disposed in the first to third separation regions with the same integration density, the first electrodes, where mutual signal interference occurs, must be spaced far apart, thereby increasing an overall area of the separation region SA. In addition, when the overall area of the separation region SA increases, it may increase the number of electrodes or traces not protected by the first protective layer 141 and the second protective layer 142, and thus, physical reliability and electrical reliability problems may occur.

In addition, if the second electrode 121 and traces having different integration densities may be disposed in the first and second separation regions and the separation distances of the separation region SA may be the same along a circumference of the inner surface of the first protective layer 141, it increases the area of electrodes and traces not covered by the first protective layer 141 or the second protective layer 142, and accordingly, it may cause a problem that the electrode or trace is delaminated due to thermal stress or the like.

Accordingly, the separation region SA has a first separation distance and a second separation distance different from each other along the circumference of the inner surface of the first protective layer 141 and the outer surface of the second protective layer 142. Therefore, the embodiment can improve signal transmission characteristics by having different circuit integration densities in the separation region SA and minimizing signal transmission loss due to a decrease in signal transmission distance. In addition, the embodiment allows a separation distance of a region having a relatively low circuit integration density among the separation regions smaller than a separation distance of a region having a high circuit integration density. Accordingly, the embodiment can minimize a reliability problem due to a trace not being covered by the first protective layer 141 or the second protective layer 142 in a separation region having a small separation distance. Furthermore, the embodiment may further improve electrical reliability and physical reliability of a semiconductor package.

Although the upper protective layer 140 is shown to be divided into a first protective layer 141 and a second protective layer 142 in the above description, the embodiment is not limited thereto. For example, the upper protective layer 140 may mean one configuration including a first opening corresponding to the separation region SA, a second opening corresponding to the first opening 141T2 of the first protective layer 141, a third opening corresponding to the second opening 141T3 of the first protective layer 141 and a fourth opening corresponding to the opening 142T of the second protective layer 142.

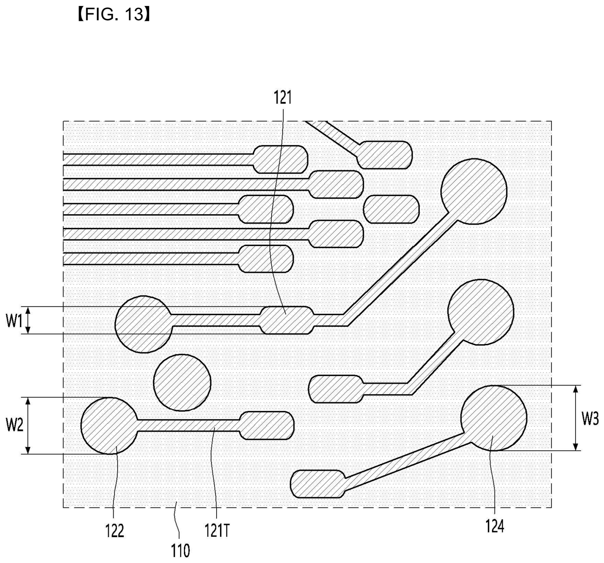

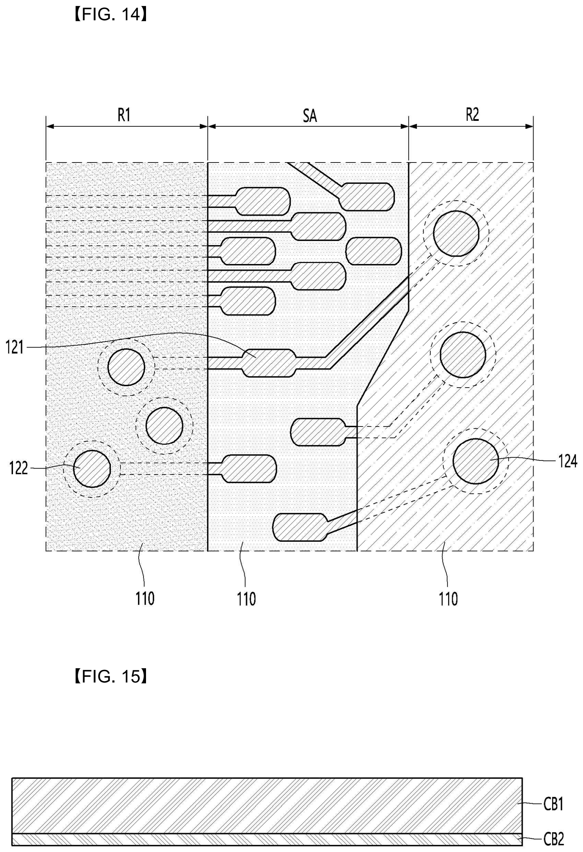

FIG. 13 is a plan view showing a first electrode part provided in region A of FIG. 1, and FIG. 14 is a plan view showing a state in which the first and second protective layers are disposed on the first electrode part of FIG. 13.

Referring to FIG. 13, the first electrode part 120 of the circuit board 100 includes a second electrode 121, a third electrode 122, and a fourth electrode 124. In addition, the first electrode part 120 of the circuit board 100 includes a trace connected to at least one of the second electrode 121, the third electrode 122, and the fourth electrode 124.

The second electrode 121, the third electrode 122, and the fourth electrode 124 each mean a pad connected to a terminal 225 of a semiconductor device 220 mounted on the circuit board 100. In addition, the first electrode 123 of the first electrode part 120 is an electrode connected to an external substrate 300 through a conductive bonding part 160.

At this time, the terminal 225 of the semiconductor device 220 is disposed on the lower surface of the semiconductor device 220. The lower surface of the semiconductor device 220 can be divided into a plurality of regions. For example, the lower surface of the semiconductor device 220 can be divided into an inner region, an outer region, and an intermediate region therebetween. Terminals 225 of the semiconductor device 220 are respectively disposed in the inner region, the outer region, and the intermediate region. In addition, the second electrode 121 of the first electrode part 120 of the circuit board 100 is connected to the terminal disposed in the intermediate region of the semiconductor device 220. In addition, the third electrode 122 of the first electrode part 120 of the circuit board 100 is connected to the terminal disposed in the outer region of the semiconductor device 220. In addition, the fourth electrode 124 of the first electrode part 120 of the circuit board 100 is connected to the terminal disposed in the inner region of the semiconductor device 220. At this time, at least one of the second electrode 121, the third electrode 122, and the fourth electrode 124 may have a different width or shape from at least one other. For example, the terminal 225 of the semiconductor device 220 may have a different size or pitch depending on an arrangement position. Accordingly, the second electrode 121, the third electrode 122, and the fourth electrode 124 may have a width or shape corresponding to the size or pitch of the terminal 225 of the semiconductor device 220.

For example, the second electrode 121 may have a different shape from the third electrode 122 and the fourth electrode 124. The second electrode 121 is connected to a terminal having a relatively small pitch and size among the terminals 225 of the semiconductor device 220. Accordingly, a planar area of the second electrode 121 may be smaller than a planar areas of the third electrode 122 and the fourth electrode 124.

At this time, the second electrode 121 may include a curved portion having a specific radius of curvature of the upper surface and a straight portion connected to the curved portion. For example, the upper surface of the second electrode 121 may include a plurality of curved portions facing each other and a plurality of straight portions connecting the plurality of curved portions. For example, a plane of the second electrode 121 may have an elliptical shape, but is not limited thereto.

At this time, a width W1 in a first horizontal direction of the second electrode 121 may be smaller than a width W2 in the first horizontal direction of the third electrode 122 and a width W3 in the first horizontal direction of the fourth electrode 124.

In addition, the width W2 in the first horizontal direction of the third electrode 122 and the width W3 in the first horizontal direction of the fourth electrode 124 may be the same as each other or may be different from each other. For example, the width W2 in the first horizontal direction of the third electrode 122 may be smaller than the width W3 in the first horizontal direction of the fourth electrode 124, but is not limited thereto. The third electrode 122 and the fourth electrode 124 have different shapes from the second electrode 121. For example, the third electrode 122 and the fourth electrode 124 may have circular shapes.

In addition, the widths of the second electrode 121, the third electrode 122, and the fourth electrode 124 in the second horizontal direction perpendicular to the first horizontal direction may be the same.

At this time, the second electrode 121 may have a circular shape in which the widths in the first horizontal direction and the second horizontal direction are the same, but in this case, an electrical short problem may occur due to overflow of the first contacting part 210 in a process of mounting the semiconductor device 220. That is, when a mounting process of the semiconductor device 220 is performed while the first contacting part 210 is disposed, pressure is applied to the first contacting part 210, and accordingly, the first contacting part 210 spreads in the horizontal direction. At this time, if the width of the second horizontal direction of the second electrode 121 is the same as the width W1 in the first horizontal direction, a problem of contact with a neighboring trace or electrode may occur as the first contacting part 210 spreads.

Therefore, the embodiment makes the second electrode 121 have an elliptical shape in which the widths in the first horizontal direction and the second horizontal direction are different from each other. Accordingly, the embodiment makes the second electrode 121 have a shape that is extended long in a direction in which there is relatively more room for pitch. Accordingly, the embodiment allows the first contacting part 210 to spread in a direction in which a risk of electrical short of the circuit is relatively low, thereby dramatically solving the electrical short problem.

In addition, the width W1 in the first horizontal direction of the second electrodes 121 disposed in the separation region SA is smaller than a size of the opening that can be formed (or according to the process capability) through exposure and development processes of the first protective layer 141 or the second protective layer 142. Accordingly, when the openings that vertically overlap with each of the second electrodes are formed after the first protective layer 141 or the second protective layer 142 is disposed in the separation region SA, an upper surface of at least one of the first electrodes may not overlap with the opening in the vertical direction due to the process capability and process deviation for forming the opening, which may cause an electrical reliability problem in which the opening is not electrically connected to the semiconductor device 220.

Accordingly, in order to minimize the area of the separation region SA while preventing the first protective layer 141 and the second protective layer 142 from being disposed in the separation region, the embodiment allows the inner surface of the through hole 141T1 of the first protective layer 141 to have a step in the horizontal direction, or the outer surface of the second protective layer 142 to have a step in the horizontal direction. Accordingly, the embodiment can improve the electrical reliability and physical reliability of the semiconductor package.

Referring to FIG. 14, the first electrode part 120 of the circuit board 100 of the embodiment includes the second electrode 121 and the first traces disposed in the separation region SA between the first protective layer 141 and the second protective layer 142.

In addition, the first electrode part 120 of the circuit board 100 includes a third electrode 122 disposed adjacent to the separation region SA and disposed in a region R1 overlapping the first opening 141T2 of the first protective layer 141 in a vertical direction.

In addition, the first electrode part 120 of the circuit board 100 includes a fourth electrode 124 disposed in a region R2 overlapping the opening 142T of the second protective layer 142 in the vertical direction.

Therefore, the embodiment allows the first protective layer 141 to have a through hole 141T1, a first opening 141T2 and a second opening 141T3, and an opening 142T of the second protective layer 142. Accordingly, the embodiment allows the second electrode 121, the third electrode 122 and the fourth electrode 124 to have different circuit integrations depending on their positions. Accordingly, the embodiment can increase the circuit integration in a specific region, thereby reducing the signal transmission distance between a plurality of electrodes, and thereby minimizing signal transmission loss and improving signal transmission characteristics. In addition, the embodiment can allow the separation distance of a region with a relatively low circuit integration among the separation regions to be smaller than the separation distance of a region with a high circuit integration. Therefore, the embodiment can minimize the reliability problem due to the trace not being covered by the first protective layer or the second protective layer in a separation region with a small separation distance. Through this, the embodiment can further improve the electrical reliability and physical reliability of the semiconductor package.

The embodiment can simplify a manufacturing process of a semiconductor package, improve the product yield, and improve physical reliability and/or electrical reliability of the semiconductor package.

That is, the semiconductor package of the embodiment includes an insulating layer and a protective layer disposed on the insulating layer. At this time, an upper surface of the protective layer has a step. Specifically, the protective layer includes a first region that overlaps the semiconductor device in a vertical direction; and a second region excluding the first region, and an upper surface of the first region and an upper surface of the second region have a step. Preferably, the upper surface of the first region is positioned lower than the upper surface of the second region. Therefore, the step between the first region and the second region of the protective layer of the embodiment can function as a dam in a process of applying a contacting part such as solder to mount the semiconductor device. For example, the step between the first region and the second region of the protective layer can guide a mounting position so that the contacting part moves to a designated position. Accordingly, the embodiment can ensure that the contacting part is mounted at an accurate position, and can provide ease of manufacturing process accordingly. Furthermore, the embodiment can prevent the contacting part from being moved to an outside of the semiconductor package and discarded by using the step between the first region and the second region of the protective layer, thereby reducing the product manufacturing cost. Furthermore, the embodiment can provide ease of manufacturing process of the semiconductor package, and further improve the product yield.

In addition, the second region of the protective layer of the embodiment is provided to surround a circumference of the conductive bonding part. Preferably, the second region of the protective layer of the embodiment is provided to entirely surround a side surface of the conductive bonding part. Accordingly, the embodiment does not need to form a separate molding member to surround the side surface of the conductive bonding part, thereby simplifying the manufacturing process.

Furthermore, the embodiment is provided such that the side surface of the conductive bonding part is entirely covered by the protective layer. Through this, the stress applied to the conductive bonding part can be minimized, and thus the reliability problem of cracks occurring at an interface between the conductive bonding part and the electrode part due to the concentration of stress on the conductive bonding part can be solved.

For example, according to a conventional technology, a part of the side surface of the conductive bonding part is covered with a protective layer, and a remaining part of the conductive bonding part is covered with a molding member. At this time, the protective layer and the molding member include different insulating materials, and thus have different thermal expansion coefficients. Therefore, one of the protective layer and the molding member may expand or contract more than the other. Therefore, different stresses may be applied to the side surface of the conductive bonding part that contacts the molding member and the side surface of the conductive bonding part that contacts the protective layer, and thus the physical reliability of the conductive bonding part may be deteriorated.

In addition, according to another conventional technology, the side surface of the conductive bonding part may be entirely in contact with the molding member. At this time, the molding member is laminated after a semiconductor device is mounted on a circuit board. Therefore, upper and side surfaces of the conductive bonding part may be entirely exposed in a process of mounting the semiconductor device. Therefore, a physical impact may be applied to the conductive bonding part in a process of mounting the semiconductor device, and as a result, a problem of the conductive bonding part being peeled off from the electrode part may occur. In addition, during a process of mounting a semiconductor device, foreign substances may accumulate on the upper surface of the conductive bonding part, which may deteriorate the electrical reliability of the conductive bonding part.

In contrast, in the embodiment, the protective layer is provided to completely surround the side surface of the conductive bonding part. Through this, the embodiment can uniformly apply stress to the entire region of the conductive bonding part according to the expansion or contraction of the protective layer, thereby solving the physical reliability problem of the conductive bonding part being peeled off from the electrode part.

Furthermore, the embodiment can stably protect the conductive bonding part from impact applied during the process of mounting a semiconductor device, thereby improving the physical reliability and/or electrical reliability of the conductive bonding part.

In addition, the protective layer of the embodiment includes a first protective layer including first and second regions and having a through hole, and a second protective layer provided at an inner side of the through hole of the first protective layer. At this time, the first protective layer includes a protruding surface protruding toward the second protective layer. For example, an outer surface of the second protective layer includes a protruding surface protruding toward the first protective layer. Accordingly, a separation distance or a spacing in a horizontal direction between the inner surface of the through hole of the first protective layer and the outer surface of the second protective layer may include different separation distances or spacings along the inner surface of the through hole. For example, the separation distance may include a first separation distance and a second separation distance. In addition, the first separation distance and the second separation distance may be different from each other. For example, the first separation distance may be greater than the second separation distance.

At this time, the embodiment may be such that second electrodes and/ traces of the electrode part having a greater density may be concentrated in the first separation region corresponding to the first separation distance than in the second separation region corresponding to the second separation distance. For example, a distance between second electrodes and/or traces disposed in the first separation region may be smaller than a distance between second electrodes and/or traces disposed in the second separation region. This means that an integration density of the electrode part in the first separation region is higher than an integration density of the electrode part in the second separation region.

In this case, the second electrodes and the traces may be disposed in the first and second separation regions with a same integration density. However, it may increase the distance between the second electrodes to be connected to each other, thereby increasing the signal transmission loss. Furthermore, when the second electrodes and traces are disposed with a same integration density in the first and second separation regions, an overall area of the separation region may increase because the first electrodes where mutual signal interference occurs should be farther apart. In addition, when the overall area of the separation region increases, a number of electrodes or traces not protected by the first protective layer and the second protective layer increases, and accordingly, it may cause physical reliability and electrical reliability problems.

In addition, first electrodes and traces having different integration densities may be disposed in the first and second separation regions, and the separation distances of the separation regions may be the same along a circumference of the inner surface of the first protective layer. However, it increases the area of electrodes and traces not covered by the first protective layer or the second protective layer, and accordingly, it may cause a problem that the electrode or trace is delaminated due to thermal stress or the like.

Accordingly, the separation region has a first separation distance and a second separation distance different from each other along the circumference of the inner surface of the first protective layer and the outer surface of the second protective layer. Therefore, the embodiment can improve signal transmission characteristics by having different circuit integration densities in the separation region and minimizing signal transmission loss due to a decrease in signal transmission distance. In addition, the embodiment allows a separation distance of a region having a relatively low circuit integration density among the separation regions smaller than a separation distance of a region having a high circuit integration density. Accordingly, the embodiment can minimize a reliability problem due to a trace not being covered by the first protective layer or the second protective layer in a separation region having a small separation distance. Furthermore, the embodiment may further improve electrical reliability and physical reliability of a semiconductor package.

FIGS. 15 to 31 are cross-sectional views for explaining a manufacturing method of a semiconductor package according to an embodiment in order of processes.

Hereinafter, with reference to FIGS. 15 to 31, a method for manufacturing a semiconductor package of FIG. 1 will be described in order of processes. Meanwhile, the semiconductor packages of the second and third embodiments may also be manufactured based on the manufacturing process described below.

Referring to FIG. 15, the embodiment prepares materials that serve as the basis for manufacturing a circuit board 100. For example, the embodiment prepares a carrier board for manufacturing a circuit board 100 of an ETS structure. The carrier board includes a carrier insulating layer CB1 and a carrier metal layer CB2 disposed on at least one surface of the carrier insulating layer CB1. Although FIG. 15 illustrates that the carrier metal layer CB2 is disposed only on the lower surface of the carrier insulating layer CB1, it is not limited thereto. For example, the carrier metal layer CB2 may also be disposed on the upper surface of the carrier insulating layer CB1. By this, the embodiment can perform a process of manufacturing a plurality of circuit boards 100 at the same time by using carrier metals CB2 respectively disposed on both sides of the carrier insulating layer CB1.

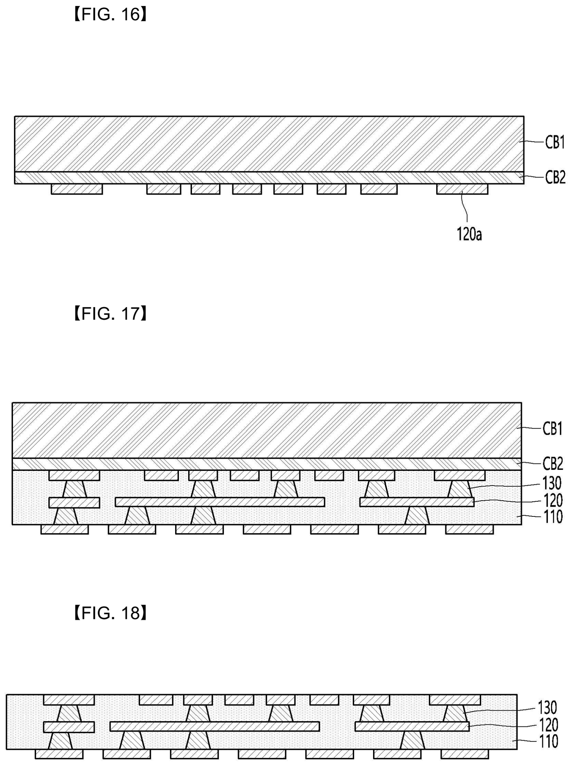

Next, referring to FIG. 16, the embodiment forms a part of a first electrode part 120 of the circuit board 100 on the lower surface of the carrier metal layer CB2 by using the carrier metal layer CB2 disposed on at least one surface of the carrier insulating layer CB1 as a seed layer. For example, the embodiment performs a process of forming electrodes 120a, which are electrode parts disposed at an uppermost side of the circuit board 100, on the lower surface of the carrier metal layer CB2.

Next, referring to FIG. 17, the embodiment may perform a process of laminating an insulating layer 110, a process of forming a through hole, a process of forming a first electrode part 120, and a process of forming a second electrode part 130 at least once when electrodes 120a are formed, thereby forming a circuit board 100.

Next, referring to FIG. 18, the embodiment may perform a process of removing a carrier board. For example, the embodiment may perform a process of separating a carrier insulating layer CB1 and a carrier metal layer CB2. Next, the embodiment may perform a process of removing a carrier metal layer CB2 disposed on the circuit board 100 by etching. However, the embodiment is not limited thereto. For example, the carrier metal layer CB2 may be used as a seed layer of the conductive bonding part 160. Therefore, the carrier metal layer CB2 may be removed by etching after the conductive bonding part 160 is formed.

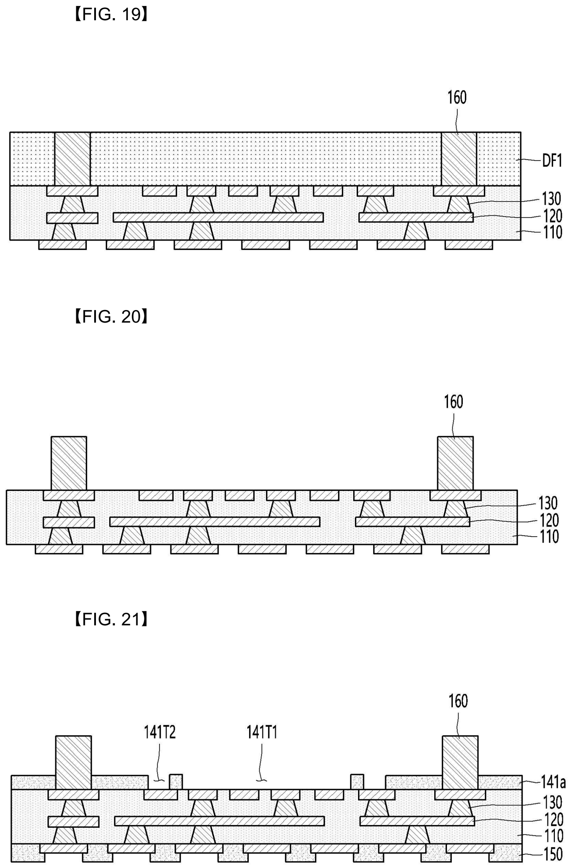

Next, referring to FIG. 19, the embodiment may perform a process of laminating a first dry film DF1 on an insulating layer 110. The first dry film DF1 includes an opening that vertically overlaps with a first electrode 121 disposed at an outer side among the electrodes 120a of the first electrode part 120. Thereafter, the embodiment performs a process of forming a conductive bonding part 160 that fills the opening of the first dry film DF1 on the first electrode 121.

Next, referring to FIG. 20, the embodiment performs a process of removing the first dry film DF1. Thereafter, the embodiment may perform a process of removing a seed layer used for electroplating the conductive bonding part 160. The seed layer may be a carrier metal layer CB2, but is not limited thereto.

Next, referring to FIG. 21, the embodiment can perform a process of forming a first layer 141a of the first protective layer 141 of the upper protective layer 140 on the circuit board 100. To this end, the embodiment can perform a process of forming a through hole 141T1 and a first opening 141T2 of the first protective layer 141 by applying an insulating material that covers the entire upper portion of the circuit board 100 and removing the applied insulating material through exposure and development.

Correspondingly, the embodiment can perform a process of forming a lower protective layer 150 on the lower portion of the circuit board 100.

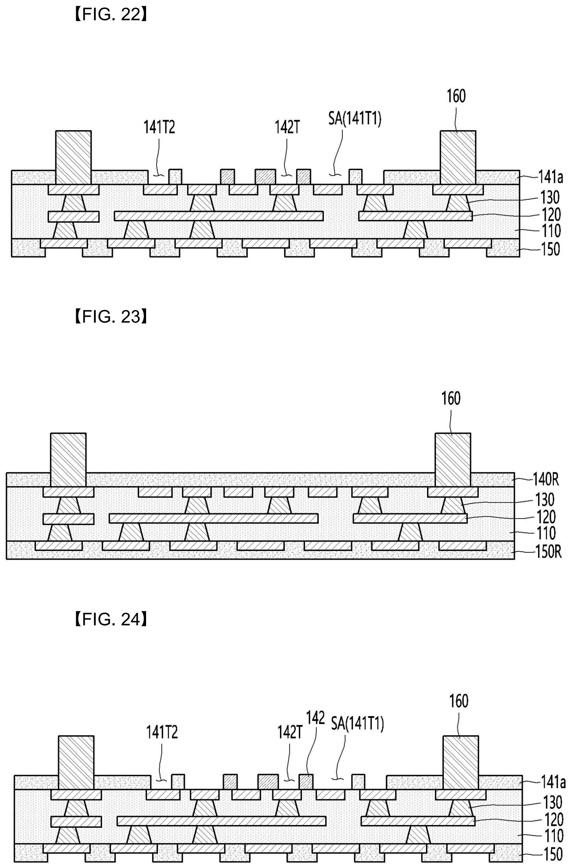

Next, referring to FIG. 22, the embodiment can perform a process of forming a second protective layer 142 at an inner side of the through hole 141T1 of the first layer 141a of the first protective layer 141 on the circuit board 100. At this time, in the process of forming the second protective layer 142, a separation region SA and an opening 142T of the second protective layer 142 may be formed between the second protective layer 142 and the first protective layer 141.

Meanwhile, the process of forming the first layer 141a of the first protective layer 141 and the second protective layer 142 is described as being performed step by step, but is not limited thereto.

For example, as illustrated in FIG. 23, the embodiment may perform a process of forming an insulating material 140R for forming the first layer 141a of the first protective layer 141 and the second protective layer 142 on the circuit board 100.

Next, as illustrated in FIG. 24, the embodiment may proceed with a process of removing the insulating material 140R by exposure and development to form a separation region SA, a first opening 141T2 of the first protective layer 141, and an opening 142T of the second protective layer 142.

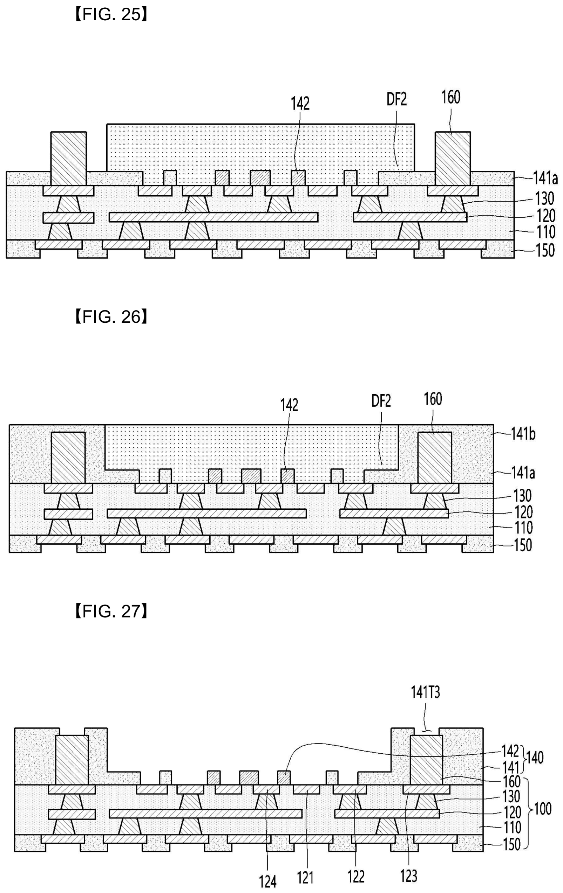

Next, as illustrated in FIG. 25, the embodiment proceeds with a process of forming a second dry film DF2 on the first layer 141a of the first protective layer 141 and the second protective layer 142. The second dry film DF2 may be formed on a remaining region except for a circumference region of the first layer 141a of the first protective layer 141.

Next, as illustrated in FIG. 26, the embodiment may perform a process of laminating the second layer 141b of the first protective layer 141 on the circumference region of the first layer 141a of the first protective layer 141 and the conductive bonding part 160 that is not covered by the second dry film DF2. The second layer 141b of the first protective layer 141 may be formed by covering the conductive bonding part 160. Through this, the first protective layer 141 may be formed by the first layer 141a and the second layer 141b. At this time, an area of the second layer 141b of the first protective layer 141 is smaller than an area of the first layer 141a. Accordingly, the first protective layer 141 may include a region formed by one layer and a region formed by two layers.

Next, as illustrated in FIG. 27, the embodiment may proceed with a process of removing the second dry film DF2. Thereafter, the embodiment may proceed with a process of forming a second opening 141T3 in a region vertically overlapping with the conductive bonding part 160 by exposing and developing the first protective layer 141.

Through this, the first protective layer 141 may be provided with a through hole 141T1, a first opening 141T2, and a second opening 141T3, while having a step on the upper surface.

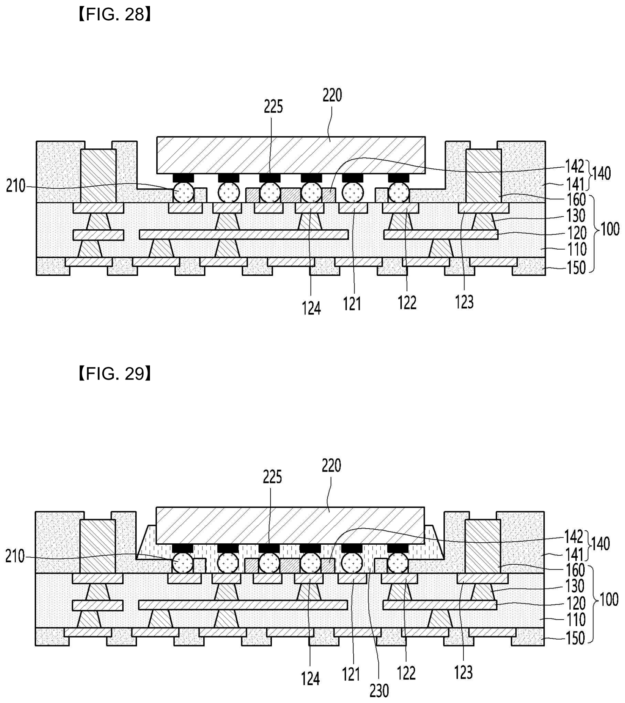

Next, as illustrated in FIG. 28, the embodiment may perform a process of placing a first contacting part 210 on the circuit board 100. For example, the embodiment may perform a process of placing the first contacting part 210 on a second electrode 121 overlapping a separation region SA in the vertical direction, a third electrode 122 overlapping a first opening 141T2 of the first protective layer 141 in the vertical direction, and a fourth electrode 124 overlapping the opening 142T of the second protective layer 142 in the vertical direction. In addition, the embodiment may perform a process of mounting a semiconductor device 220 on the first contacting part 210. Accordingly, the terminal 225 of the semiconductor device 220 can be electrically connected to the second electrode 121, the third electrode 122, and the fourth electrode 124 through the first contacting part 210, respectively. At this time, the semiconductor device 220 has a structure in which it is disposed on the second protective layer 142. Furthermore, at least a part of the semiconductor device 220 can have a structure in which it is disposed on the first protective layer 141. At this time, although FIG. 28 illustrates that one semiconductor device is mounted on the circuit board, it is not limited thereto. For example, a plurality of semiconductor devices can be mounted on the circuit board while being spaced apart from each other in the horizontal direction. At this time, a connection member 500 that horizontally connects the plurality of semiconductor devices can be provided within the circuit board.

Next, as illustrated in FIG. 29, the embodiment can perform a process of forming an underfill 230 that covers a periphery of the semiconductor device 220 mounted on the circuit board 100. At this time, the underfill 230 can be formed at a designated location through a step between the first region 141R1 and the second region 141R2 of the first protective layer 141.

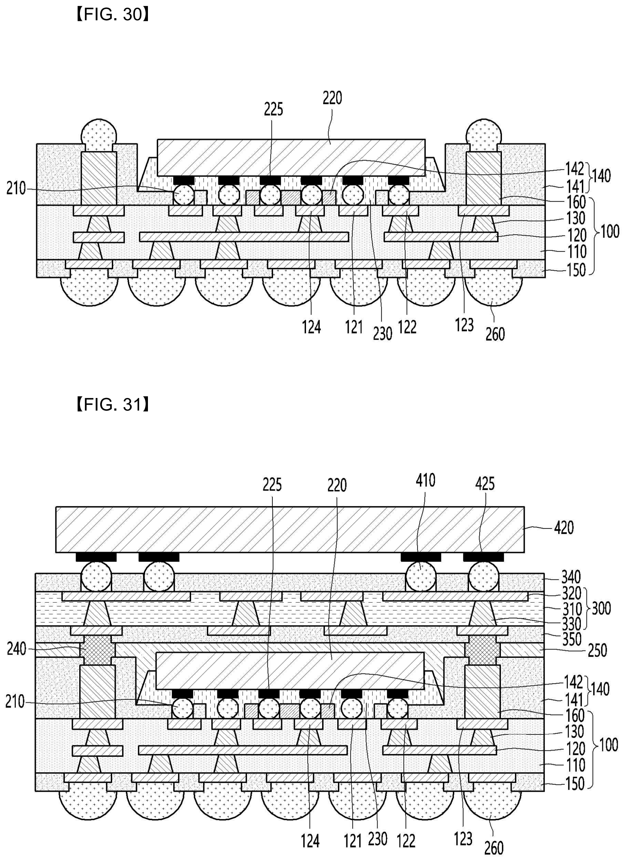

Next, as illustrated in FIG. 30, the embodiment can proceed with a process of forming a second contacting part 240 on a conductive bonding part 160 that vertically overlaps the second opening 141T3 of the first protective layer 141. In addition, the embodiment can proceed with a process of forming a third contacting part 260 on the opening of the lower protective layer 150 disposed on the lower surface of the circuit board 100.

Next, as illustrated in FIG. 31, the embodiment may perform a process of forming a molding layer 250 that molds an upper portion of the first protective layer 141, the upper portion of the second protective layer 142, the second contacting part 240, the semiconductor device 220, and the underfill 230. At this time, the embodiment may omit a process of forming the underfill 230. Accordingly, the embodiment may perform a process of molding the semiconductor device 220 using the molding layer 250. In addition, the embodiment may perform a process of attaching an external substrate 300 on which a semiconductor device 420 is mounted on the second contacting part 240.

On the other hand, when the circuit board having the above-described characteristics of the invention is used in an IT device or home appliance such as a smart phone, a server computer, a TV, and the like, functions such as signal transmission or power supply can be stably performed. For example, when the circuit board having the features of the present invention performs a semiconductor package function, it can function to safely protect the semiconductor chip from external moisture or contaminants, or alternatively, it is possible to solve problems of leakage current, electrical short circuit between terminals, and electrical opening of terminals supplied to the semiconductor chip. In addition, when the function of signal transmission is in charge, it is possible to solve the noise problem. Through this, the circuit board having the above-described characteristics of the invention can maintain the stable function of the IT device or home appliance, so that the entire product and the circuit board to which the present invention is applied can achieve functional unity or technical interlocking with each other.

When the circuit board having the characteristics of the invention described above is used in a transport device such as a vehicle, it is possible to solve the problem of distortion of a signal transmitted to the transport device, or alternatively, the safety of the transport device can be further improved by safely protecting the semiconductor chip that controls the transport device from the outside and solving the problem of leakage current or electrical short between terminals or the electrical opening of the terminal supplied to the semiconductor chip. Accordingly, the transportation device and the circuit board to which the present invention is applied can achieve functional integrity or technical interlocking with each other. Furthermore, when the circuit board having the above-described characteristics of the invention is used in a transportation device such as a vehicle, it is possible to transmit a high-current signal required by the vehicle at a high speed, thereby improving the safety of the transportation device. Furthermore, the circuit board and the semiconductor package including the same can be operated normally even in an unexpected situation occurring in various driving environments of the transportation device, thereby safely protecting the driver.

Features, structures, effects, etc. described in the above embodiments are included in at least one embodiment, and it is not necessarily limited to only one embodiment. Furthermore, features, structures, effects, etc. illustrated in each embodiment can be combined or modified for other embodiments by those of ordinary skill in the art to which the embodiments belong. Accordingly, the contents related to such combinations and variations should be interpreted as being included in the scope of the embodiments.

In the above, the embodiment has been mainly described, but this is only an example and does not limit the embodiment, and those of ordinary skill in the art to which the embodiment pertains will appreciate that various modifications and applications not illustrated above are possible without departing from the essential characteristics of the present embodiment. For example, each component specifically shown in the embodiment can be implemented by modification. And the differences related to these modifications and applications should be interpreted as being included in the scope of the embodiments set forth in the appended claims.

## Claims

1. A semiconductor package comprising:
an insulating layer;
an electrode part disposed on the insulating layer;
a protective layer disposed on the electrode part; and
a semiconductor device disposed on the protective layer,
wherein the protective layer includes:
a first region that overlaps the semiconductor device in a vertical direction, and
a second region that is disposed at an outside of the first region and does not overlap the semiconductor device in the vertical direction, and
wherein a step is provided between an upper surface of the first region and an upper surface of the second region.

2. The semiconductor package of claim 1, wherein the upper surface of the first region is positioned lower than the upper surface of the second region.

3. The semiconductor package of claim 1 or 2, wherein the second region is provided along a circumferential direction of an upper surface of the protective layer, and
wherein the first region is provided at an inside of the second region.

4. The semiconductor package of claim 1, wherein the upper surface of the second region of the protective layer is positioned higher than a lower surface of the semiconductor device and lower than an upper surface of the semiconductor device.

5. The semiconductor package of claim 1, wherein the protective layer includes:
a first protective layer disposed on the insulating layer and including a through hole overlapping the semiconductor device in the vertical direction; and
a second protective layer disposed inside the through hole of the first protective layer and spaced apart from the first protective layer.

6. The semiconductor package of claim 5, wherein the first protective layer includes the first region and the second region, and
wherein an upper surface of the second protective layer is disposed on a same plane as the upper surface of the first region of the first protective layer.

7. The semiconductor package of claim 5, wherein the first protective layer includes the first region and the second region, and
wherein an upper surface of the second protective layer is positioned lower than the upper surfaces of each of the first and second regions of the first protective layer.

8. The semiconductor package of claim 5, further comprising:
a conductive bonding part passing through at least a part of the second region of the first protective layer,
wherein the conductive bonding part is disposed on a first electrode of the electrode part that does not overlap with the semiconductor device in the vertical direction,
wherein the second region of the first protective layer includes a first opening that overlaps with the conductive bonding part in the vertical direction, and
wherein the second region of the first protective layer is provided to entirely surround a side surface of the conductive bonding part.

9. The semiconductor package of claim 8, wherein an upper surface of the conductive bonding part is positioned higher than a lower surface of the semiconductor device and lower than an upper surface of the semiconductor device.

10. The semiconductor package of claim 5, wherein an inner surface of the through hole of the first protective layer includes a protruding surface protruding toward the second protective layer.
